(19) Europäisches Patentamt
European Patent Office
Office européen des brevets

(11) **EP 4 645 177 A1**

(12) **EUROPEAN PATENT APPLICATION**

(43) Date of publication:
**05.11.2025 Bulletin 2025/45**

(21) Application number: **24305679.3**

(22) Date of filing: **30.04.2024**

(51) International Patent Classification (IPC):
*G06N 10/20* (2022.01)

(52) Cooperative Patent Classification (CPC):
**G06N 10/20**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **BULL SAS**
**78340 Les Clayes-Sous-Bois (FR)**

(72) Inventor: **VANDAELE, Vivien**
**59218 VENDEGIES-AU-BOIS (FR)**

(74) Representative: **Plasseraud IP**
**104 Rue de Richelieu
CS92104
75080 Paris Cedex 02 (FR)**

(54) **DATA PROCESSING METHOD AND APPARATUSES FOR IMPLEMENTING THE SAME**

(57) A data processing method for processing a first quantum circuit represented by a combination of quantum gates that comprises one or more T quantum gates is proposed, which comprises comprising: Generating a parity table P that corresponds to the first quantum circuit, wherein the parity table is a Boolean matrix of size $n \times m$, where n corresponds to a number of qubits on which the first quantum circuit operates, and $m$ corresponds to a number of $T$ quantum gates in the first quantum circuit, determining a Boolean vector $y$ of size $m$ that satisfies a column reduction condition which comprises $L \cdot y = 0$, wherein $L$ is a matrix determined based on a matrix whose rows are forming the set $\{P_i \wedge P_j | 0 \le i \le j < n\}$, determining a second parity table P' that is equivalent to the first parity table P, based on the vector y, and the first parity table P, determining a third parity table P" based on removing at least one column of the second parity table P'; and updating the first quantum circuit based on the third parity table P".

FIG. 4

**Description**

The present subject disclosure relates to the field of quantum computing, in particular to the processing of data representing a quantum circuit executable on a quantum computer.

In the field of quantum computing, a quantum computing program, that is, a program that is executable on a quantum computer, can be generated from a quantum circuit that corresponds to the program. Quantum circuit synthesis corresponds to the decomposition of a unitary operator that corresponds to a quantum circuit into a sequence of quantum gates.

Among the cost metrics characterizing a quantum circuit, the T-count (measuring the number of T gates in the circuit) stands out as one of the most crucial as its minimization is particularly important in various areas of quantum computation such as fault-tolerant quantum computing and quantum circuit simulation.

Another example of quantum compilers which aim at reducing or minimizing the resources needed to execute a given quantum algorithm. As the number of T gates typically impact such resources, it is desirable to reduce or minimize the number of T gates in a given quantum circuit to be processed by a quantum compiler.

There is therefore a need for an improved data processing method for reducing the T-count of an input quantum circuit that addresses the drawbacks and shortcomings, or improves the performances of the conventional technology in the art.

In particular, it is an object of the present subject disclosure to provide an improved data processing method for execution on a computational device that addresses the drawbacks and shortcomings of the conventional technology in the art.

Another object of the present subject disclosure is to provide a data processing method suitable for reducing the T-count of an input quantum circuit using a computer with improved T-count reduction efficiency.

Yet another object of the present subject disclosure is to provide a data processing method suitable for minimizing the T-count of an input quantum circuit using a computer.

To achieve these objects and other advantages and in accordance with the purpose of the present subject disclosure, as embodied and broadly described herein, in one aspect of the present subject disclosure, a data processing method for use on a (quantum or classical) computational device is proposed.

The proposed method may comprise, for processing a first quantum circuit represented by a combination of quantum gates that comprises one or more $T$ quantum gates: Generating a parity table $P$ that corresponds to the first quantum circuit, wherein the parity table is a **Boolean** matrix of size $n \times m$, where $n$ may correspond to a number of qubits on which the first quantum circuit operates, and $m$ corresponds to a number of $T$ quantum gates in the first quantum circuit; determining a (Boolean) vector $y$ of size $m$ that satisfies a column reduction condition which comprises $L \cdot y = 0$, wherein $L$ is a matrix determined based on a matrix whose rows are forming the set $\{P_i \wedge P_j | 0 \leq i \leq j < n\}$, wherein $P_k$ designates a vector corresponding to a row of index $k$ of the parity table $P$, and $\wedge$ designates a logical AND operation; determining a second parity table $P'$ that is equivalent to the first parity table $P$, based on the vector $y$, and the first parity table $P$; determining a third parity table $P''$ based on removing at least one column of the second parity table $P'$; and updating the first quantum circuit based on the third parity table $P''$. In some embodiments, $m$ may correspond to a number of parities in a phase polynomial $p$ that corresponds to the first quantum circuit.

In one or more embodiments, the proposed method may further comprise: Determining a (Boolean) vector $z$ of size $n$ for which the second parity table $P'$ has at least one pair of columns that are identical to each other or at least one column which is equal to the null vector, and the second parity table $P'$ may be based on $P \oplus zy^T$, and $\oplus$ designates a logical XOR operation.

In some embodiments, the vector $z$ may be determined based on a vector of a set $Z$, and the set $Z$ may comprise one or more of the subsets $\{P_{:,i} \oplus P_{:,j} | 0 \leq i < j < m\}$ and $\{P_{:,i} | 0 \leq i < m\}$, wherein $P_{:,k}$ is the column of index $k$ of the first parity table $P$, and $\oplus$ designates a logical XOR operation.

In such embodiments, the proposed method may further comprise: performing iterations of a column reduction loop for determining an optimum vector $z_0$ of size $n$ in the set of vectors $Z$ for which the second parity table $P'$ has a maximum number of pairs of columns that are identical to each other among the vectors of the set of vectors $Z$. In such embodiments, the optimum vector $z_0$ may be determined based on an objective function that counts the number of columns that can be removed from the second parity table, for example as being all-zero columns or ones of a pair of columns that are duplicate from each other.

In one or more embodiments, the proposed method may further comprise: Based on the additional condition $|y| \equiv 1 \ (mod \ 2)$ being satisfied by the vector $y$, wherein $|y|$ designates a Hamming weight of the vector $y$, updating the second parity table $P'$ by adding the determined vector $z$ as an additional column in the second parity table $P'$. The at least one column removed for updating the second parity table $P'$ may be identical to another column of the second parity table updated by adding the additional column.

In one or more embodiments, based on the vector $y$ satisfying $y = 1$ and $|y| = 0 \ (mod \ 2)$, where $|y|$ designates a Hamming weight of the vector $y$, the second parity table $P'$ may be based on $P \oplus P_{:,i} y^T$, where $P_{:,i}$ is the column of index $i$ of the first parity table $P$, and the at least one column removed for updating the second parity table $P'$ may be equal to the null vector (all-zero vector), and $\oplus$ designates a logical XOR operation.

In one or more embodiments, based on the vector $\boldsymbol{y}$ satisfying $\boldsymbol{y} \neq \boldsymbol{0}$ and $\boldsymbol{y} \neq \boldsymbol{1}$, the second parity table $P'$ may be based on $P \oplus \boldsymbol{z}\boldsymbol{y}^T$, where the vector $\boldsymbol{z}$ is a Boolean vector of size $n$ for which the second parity table $P'$ has at least one pair of columns that are identical to each other, and the at least one column removed for updating the second parity table $P'$ may be one of the least one pair of columns that are identical to each other.

In one or more embodiments, the proposed method may further comprise: Determining a plurality of Boolean vectors $\boldsymbol{y}$ that satisfy the column reduction condition which comprises $L \cdot \boldsymbol{y} = \boldsymbol{0}$, determining one or more Boolean vectors $\boldsymbol{z}$ of size $n$ for which, for a respective one of the plurality of Boolean vectors $\boldsymbol{y}$, the second parity table $P'$ has at least one pair of columns that are identical to each other or at least one column which is an all-zero column, and the second parity table $P'$ may be based on $P \oplus \boldsymbol{z}\boldsymbol{y}^T$, and $\oplus$ designates a logical XOR operation. In such embodiments, the proposed method may further comprise: performing iterations of a column reduction loop for determining an optimum vector $\boldsymbol{y_0}$ in the plurality of Boolean vectors $\boldsymbol{y}$ and an optimum vector $\boldsymbol{z_0}$ in the one or more Boolean vectors $\boldsymbol{z}$ for which the second parity table $P'$ has a maximum number of columns that can be removed from the second parity table as being an all-zero column or one of a pair of columns that are identical to each other.

In one or more embodiments, the proposed method may comprise: maximizing the value $f(\boldsymbol{y_0}, \boldsymbol{z_0})$ where $f$ is defined as the following objective function:

$$f(\boldsymbol{y}, \boldsymbol{z}) = -|\boldsymbol{y}| \,(mod\ 2) + \sum_{\{i,j\}\in S^{(z)}} 2\left(y_i \oplus y_j\right) + \delta_{ij}\left[y_i + 2(y_i \oplus 1)(|y|(mod2))\right]$$

wherein $S^{(z)}$ comprises the set of indices $\{\{i,j\}|P_{:,i} \oplus P_{:,j} = \boldsymbol{z}\} \cup \{\{i,i\}|P_{:,i} = \boldsymbol{z}\}$, and $\oplus$ designates a logical XOR operation.

In some embodiments, the proposed method may further comprise: determining the set of indices $S^{(z)}$ by performing iterations of a second column reduction loop. In embodiments, an iteration may comprise: For a vector $\boldsymbol{z}$ of the set $Z$ respectively corresponding to the iteration, computing a pair of indices $\{i,j\}$ that satisfies (a) $P_{:,i} \oplus P_{:,j} = \boldsymbol{z}$ ($\oplus$ designates a logical XOR operation) in a case where $i \neq j$ or (b) $P_{:,i} = \boldsymbol{z}$ in a case where $i = j$.

In one or more embodiments, the proposed method may further comprise: producing a second quantum circuit that corresponds to the first quantum circuit updated based on the third parity table.

According to another aspect, a non-quantum computational device is proposed, which comprises a processor and a memory operatively coupled to the processor, wherein the device is configured to perform embodiments of a method proposed in the present subject disclosure.

According to yet another aspect, a quantum computational device is proposed, which comprises a quantum processor and a (quantum) memory operatively coupled to the quantum processor, wherein the device is configured to perform embodiments of a method proposed in the present subject disclosure.

According to yet another aspect, a computational device is proposed, which is configured to perform embodiments of a method proposed in the present subject disclosure.

According to yet another aspect, a computer program product comprising computer program code (e.g. tangibly) embodied in a computer readable medium is proposed, said computer program code comprising instructions to, when provided to a computer system and executed, cause said computer to perform embodiments of a method proposed in the present subject disclosure.

According to yet another aspect, a computer program product comprising computer program code (e.g. tangibly) embodied in a computer readable medium is proposed, said computer program code comprising instructions to, when provided to a non-quantum computer system and executed, cause said computer to perform embodiments of a method proposed in the present subject disclosure.

According to yet another aspect, a data set representing, for example through compression or encoding, a proposed computer program product is proposed.

It should be appreciated that the present invention can be implemented and utilized in numerous ways, including without limitation as a process, an apparatus, a system, a device, and as a method for applications now known and later developed. These and other unique features of the system disclosed herein will become more readily apparent from the following description and the accompanying drawings.

## Brief description of the drawings

The present subject disclosure will be better understood and its numerous objects and advantages will become more apparent to those skilled in the art by reference to the following drawings, in conjunction with the accompanying specification, in which:

Figure 1a is an exemplary diagram illustrating a quantum *NOT* gate;
Figure 1b is an exemplary diagram illustrating a quantum *CNOT* gate;
Figure 1c is an exemplary diagram illustrating a quantum *T* gate;
Figure 1d is an exemplary diagram illustrating a quantum Hadamard gate;
Figure 2 is an exemplary diagram illustrating a quantum CCZ gate;
Figure 3 illustrates an exemplary implementation of a weighted polynomial associated with the CCZ quantum gate in accordance with one or more embodiments;
Figure 4 is a block diagram illustrating an exemplary data processing method, in accordance with one or more embodiments;
Figure 5 illustrates an exemplary algorithm for T-count optimization in accordance with one or more embodiments;
Figure 6 illustrates an exemplary architecture of a quantum computational device in accordance with one or more embodiments.

## Description of embodiments

The advantages, and other features of the components disclosed herein, will become more readily apparent to those having ordinary skill in the art form. The following detailed description of certain preferred embodiments, taken in conjunction with the drawings, sets forth representative embodiments of the subject technology, wherein like reference numerals identify similar structural elements.

For simplicity and clarity of illustration, the drawing figures illustrate the general manner of construction, and descriptions and details of well-known features and techniques may be omitted to avoid unnecessarily obscuring the discussion of the described embodiments of the subject disclosure. Additionally, elements in the drawing figures are not necessarily drawn to scale. For example, the dimensions of some of the elements in the figures may be exaggerated relative to other elements to help improve understanding of embodiments of the present subject disclosure. Certain figures may be shown in an idealized fashion in order to aid understanding, such as when structures are shown having straight lines, sharp angles, and/or parallel planes or the like that under real-world conditions would likely be significantly less symmetric and orderly.

In addition, it should be apparent that the teaching herein can be embodied in a wide variety of forms and that any specific structure and/or function disclosed herein is merely representative. In particular, one skilled in the art will appreciate that an aspect disclosed herein can be implemented independently of any other aspects and that several aspects can be combined in various ways.

The present disclosure is described below with reference to functions, engines, block diagrams and flowchart illustrations of the methods, systems, and computer program according to one or more exemplary embodiments. Each described function, engine, block of the block diagrams and flowchart illustrations can be implemented in hardware, software, firmware, middleware, microcode, or any suitable combination thereof. If implemented in software, the functions, engines, blocks of the block diagrams and/or flowchart illustrations can be implemented by computer program instructions or software code, which may be stored or transmitted over a computer-readable medium, or loaded onto a general purpose non quantum computer, special purpose non quantum computer or other programmable data processing apparatus to produce a machine, such that the computer program instructions or software code which execute on the non-quantum computer or other programmable data processing apparatus, create the means for implementing the functions described herein.

Embodiments of computer-readable media includes, but are not limited to, both computer storage media and communication media including any medium that facilitates transfer of a computer program from one place to another. As used herein, a "computer storage media" may be any physical media that can be accessed by a computer. Examples of computer storage media include, but are not limited to, a flash drive or other flash memory devices (e.g. memory keys, memory sticks, key drive), CD-ROM or other optical storage, DVD, magnetic disk storage or other magnetic storage devices, memory chip, RAM, ROM, EEPROM, smart cards, Solid State Drive (SSD) devices or Hard Disk Drive (HDD) devices, or any other suitable medium from that can be used to carry or store program code in the form of instructions or data structures which can be read by a computer processor. Also, various forms of computer-readable media may transmit or carry instructions to a computer, including a router, gateway, server, or other transmission device, wired (coaxial cable, fiber, twisted pair, DSL cable) or wireless (infrared, radio, cellular, microwave). The instructions may comprise code from any computer-programming language, including, but not limited to, assembly, C, C++, Visual Basic, HTML, PHP, Java, Javascript, Python, and bash scripting.

Unless specifically stated otherwise, it will be appreciated that throughout the following description discussions utilizing terms such as processing, computing, calculating, determining, generating, or the like, refer to the action or processes of a computer or computing system, or similar electronic computing device, that manipulate or transform data represented as physical, such as electronic, quantities within the registers or memories of the computing system into other data similarly represented as physical quantities within the memories, registers or other such information storage, transmission or display devices of the computing system.

The terms "comprise," "include," "have," and any variations thereof, are intended to cover a non-exclusive inclusion, such that a process, method, article, or apparatus that comprises a list of elements is not necessarily limited to those elements, but may include other elements not expressly listed or inherent to such process, method, article, or apparatus.

Additionally, the word "exemplary" as used herein means serving as an example, instance, or illustration. Any aspect or design described herein as "exemplary" is not necessarily to be construed as preferred or advantageous over other aspects or designs.

As used herein, the notation "$|0\rangle$" designates the quantum state "ket-zero", and the notation "$|1\rangle$" designates the quantum state "ket-one", that may each be used as an initial quantum state in a quantum circuit.

As used herein, the terms "qubit", "qu-bit", and "qbit" may be used interchangeably to refer to a quantum bit in the context of quantum computing, which corresponds to a two-state quantum-mechanical system, such as, for example, the spin of an electron (spin-up or spin-down), the polarization of a photon (left-handed or righ-handed circular polarization). A qubit may be in a coherent superposition of multiple states simultaneously. Quantum data may comprise one or more qubits or a vector of qubits.

As used herein, the terms "T-count' and "T-depth" may be used interchangeably to refer to, depending on the embodiment, the number of T quantum gates in a quantum circuit or the number of T-stages in a quantum circuit. A "T-stage" may refer to a group of one or more quantum gates among one or more of $T$ gates and conjugate $T^\dagger$ gates acting on distinct qubits and that can be performed simultaneously with respect to each other. For the purpose of determining the T-count of a quantum circuit, the quantum gates $T$ and $T^\dagger$ (which designate a quantum conjugate $T$ gate as described below) may be treated interchangeably in some embodiments.

The terms "quantum" or "quantum computing" as used in the present subject disclosure are intended to cover any computer, computing system, processing or computing operation, configured to use or exploit quantum mechanical phenomena. A computer, processor, calculator, computing system, computing node, computing task, computer job, processing, algorithm, and processing resource configured to use or exploit quantum mechanical phenomena will be referred to herein as "quantum" (a quantum computer, quantum processor, quantum calculator, quantum computing system, quantum computing node, quantum computing task, quantum computer job, quantum processing, quantum algorithm, and quantum processing resource, respectively. In contrast, a computer, processor, calculator, computing system, computing node, computing task, computerjob, processing, algorithm, and processing resource which is not configured to use or exploit quantum mechanical phenomena may be referred to herein as "classical" or "non-quantum" (a classical computer, classical processor, classical calculator, classical computing system, classical computing system, classical computing node, classical computing task, classical computer job, classical algorithm, classical processing, classical processing resource, respectively). A quantum processor (also referred to herein as a quantum processing unit (or QPU)) may be configured to perform both quantum processing and classical processing.

The term "hybrid" as used in the present subject disclosure, for example as applied to a computer, an algorithm, a computer task, a computer job, refers to the combination of classical and quantum.

The present subject disclosure may advantageously be implemented on any suitable computing environment, such as, for example, comprising a hybrid computer configured with one or more classical resources (e.g. one or more CPUs) and one or more quantum processing resources (e.g. one or more QPUs), such as a hybrid HPC cluster, an electronic component, an electronic chipset, a QPU, an electronic circuitboard, an electronic circuit, a quantum processing chipset, a quantum computer, etc.

In quantum computing, a computing operation may be described by its result modeled in the form of a target quantum state (denoted $|\psi_{target}\rangle$). Obtaining a direct description of such target quantum state is typically not considered for achieving this state, as describing the target quantum state as a complex vector is inherently inefficient as it comes at an exponential computational cost.

For this reason, another approach for preparing a target quantum state focuses on a quantum circuit capable of preparing the desired target quantum state. The quantum circuit may be described as the decomposition of a unitary operator $U$ (that corresponds to the quantum circuit) into a sequence of one or more quantum gates $U_1, ..., U_n$, and operating on an initial quantum state (e.g. $|0\rangle$) comprising one or two qubits. Therefore the target quantum state may be described as the output of the quantum circuit operating on the initial quantum state, for example according to the following equation:

$$|\psi_{target}\rangle = U_n \cdots U_1 |0\rangle$$

The proposed scheme may advantageously be implemented in any computing environment comprising quantum computational device configured according to one or more embodiments of the present subject disclosure, such as, for example a quantum processor or a quantum processing unit configured with one or more quantum gates.

As used herein, the terms "quantum gate", "quantum logic gate", or "gate" may be used interchangeably to refer to an operator which performs an operation on input data suitable for representing one or more qubits.

In the present subject disclosure, the term "apply" or its derivatives may be used, in particular with respect to a quantum gate operation and input data, to refer to the performing the quantum gate operation on the input data.

In the present subject disclosure, the terms "tensor product" and "Kronecker product" may be used interchangeably to refer to a tensor product operation between 2 or more matrices, for example 2 or more $2 \times 2$ matrices with each of the matrix in the product corresponding to a matrix of the set $S = \{I, X, Y, Z\}$.

In the present subject disclosure, 1-dimensional vectors may be denoted with respective letters in bold, such as for example the vectors $\boldsymbol{y}$ and $\boldsymbol{z}$. Further, the row of index $i$ of a matrix $A$ may be denoted $A_i$ (elements of such row may form a vector which may also be denoted $A_i$), and the column of index $j$ of the matrix $A$ may be denoted $A_{.j}$. Further, the symbol "$\oplus$" may be used to designate a logical XOR operation, and the symbol "$\wedge$" may be used to designate a logical AND operation.

For technical reasons, the majority of today's quantum computers can only implement gates acting on 1 or 2 qubits.

When considering the complexity of implementing a circuit on a quantum computer, several questions arise, among which the question of which gates may be used to implement the circuit. In one or more embodiments, a decomposition of the proposed circuit into 1- or 2-qubit gates, may be considered for purposes of comparison between different technologies (for implementing the gates, e.g. using photons, ions), but also for practical reasons: In some embodiments, quantum computers used for implementing embodiments of the present subject disclosure may be configured to only use these elementary gates. In one or more embodiments, a set of quantum gates into which any other gate can be decomposed may be chosen, and performance metrics may be defined to evaluate the performance of an implementation.

Because any quantum gate acting on any number of qubits may be decomposed in a combination of one or more of 1-qubit gate and 2-qubit gate, the set of the 1-qubit and 2-qubit gates is sometimes referred to as a universal gate set. In some embodiments, a set of quantum gates that is approximately universal, that is, a set of quantum gates that typically comprise a limited number of gates that are sufficient to approximate any quantum gate to any desired precision, may advantageously be used to build the quantum gates used in embodiments of the present subject disclosure.

Quantum computing typically involve qubits undergoing one or more quantum logic gate operations.

In some applications, designing quantum algorithms for execution on a quantum computer require expressing matrices used by the algorithm in a suitable manner for execution on a quantum computer.

Pauli matrices are widely used in the field of quantum computing, for example for computing a Hamiltonian of a quantum system, which typically involve computing tensor products (sometimes referred to as Kronecker products) of n matrices of the set $S = \{I, X, Y, Z\}$ of 2-by-2 matrices comprising the identity matrix $I = \begin{bmatrix} 1 & 0 \\ 0 & 1 \end{bmatrix}$ and the $X$, $Y$, and $Z$ Pauli matrices of complex numbers.

Pauli matrices (and the identity matrix) are 2-by-2 matrices which are used in both the quantum physics and quantum computing fields.

In some embodiments, one may therefore consider the following set $S = \{I, X, Y, Z\}$ of 2-by-2 matrices comprising the identity matrix:

$$I = \begin{bmatrix} 1 & 0 \\ 0 & 1 \end{bmatrix}$$

and the following $Z$, $Y$, and $Z$ Pauli matrices of complex numbers:

$$X = \begin{bmatrix} 0 & 1 \\ 1 & 0 \end{bmatrix}$$

$$Y = \begin{bmatrix} 0 & -i \\ i & 0 \end{bmatrix}$$

$$Z = \begin{bmatrix} 1 & 0 \\ 0 & -1 \end{bmatrix}$$

For example, the $X$ matrix applied to a quantum state operates to invert such quantum state, and the $Y$ matrix applied to a quantum state operates to invert such state with a phase shift of $+i$ or $-i$.

Based on the set $S = \{I, Z, Y, Z\}$, a Pauli operator basis $\wp_n$, of size $n \in \mathbb{N}^*$ ($n$ being a non-nil natural integer that corresponds to operations performed in a quantum system of $n$-qubits) can be defined as all the possible tensor products of $n$ matrices of the set S:

$$\wp_n = \{\otimes_n M_n, M_n \in \{I, X, Y, Z\}\}$$

The Pauli operator basis $\wp_n$ is a basis of $\mathbb{C}^{2^n \times 2^n}$, so that any matrix $A$ of $\mathbb{C}^{2^n \times 2^n}$ can be decomposed in this basis, as a linear combination of elements of this basis:

$$A = \sum_{P_i \in \wp_n} \alpha_i \cdot P_i$$

with $P_i \in \wp_n$, and $\alpha_i \in \mathbb{C}$ are decomposition complex coefficients.

A so-called "Pauli rotation" $R_P(\theta)$ may be defined as follows:

$$R_P(\theta) = \exp(-i\theta P/2) = \cos(\theta/2)I - i\sin(\theta/2)P$$

For a Pauli operator $P \in \wp_n$, and an angle $\theta \in \mathbb{R}$.

Different quantum gates may be used in a quantum circuit as elementary quantum circuits operating on a given number of qubits. As they are the building blocks of a quantum circuit, 1-qubit and 2-qubit gates are considered to have a size / quantum cost of 1, and a depth / delay of 1 (the delay of execution of an elementary gate, that is, a 1 qubit or 2-qubit gate, may sometimes be denoted $\Delta$ in the present subject disclosure). In some embodiments, 3-qubit gates such as the Toffoli gate, Fredkin gate and Peres gate may be considered for designing arithmetic circuits. Depending on the embodiment, these 3-qubit gates may be implemented using any suitable (approximate) universal gate sets, such as the exemplary approximate universal gate sets described above.

In contrast to logic gates (used in non-quantum computational devices), quantum gates are typically designed to be reversible, so that any quantum circuit corresponding to a sequence of one or more quantum gates can itself be reversible.

Controlled quantum gates are gates that operate on two or more qubits, wherein one or more qubits operate to control operations of the gate.

Reference may be made in the present subject-disclosure to the following quantum gates:

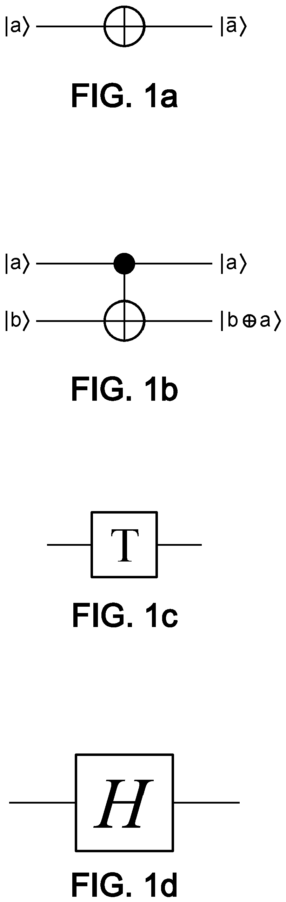

Fig. 1a shows a diagram representing a quantum NOT gate.

A quantum NOT gate (also referred to as "Pauli-X gate") performs a NOT operation on quantum data comprising an input qubit. The NOT operation corresponds to a XOR logical operation for a logic gate: the output qubit is $|1\rangle$ for an input qubit of $|0\rangle$, and the output qubit is $|0\rangle$ for an input qubit of $|1\rangle$.

With respect to an input qubit $|a\rangle$, the binary complement of $|a\rangle$ that is the output qubit of a quantum NOT gate applied to $|a\rangle$ may be denoted $|\bar{a}\rangle$ or $|a \oplus 1\rangle$.

A quantum NOT gate may be represented by a Pauli matrix $X$:

$$X = \begin{bmatrix} 0 & 1 \\ 1 & 0 \end{bmatrix}$$

Fig. 1b shows a diagram representing a quantum Controlled-NOT gate.

The Controlled-NOT gate (which may be referred herein to as a "CNOT" gate) is a controlled quantum gate which performs a NOT operation on input quantum data comprising a first input qubit depending on a second input qubit (which may be referred to as the "control bit").

For example, as illustrated on Fig. 1b, a quantum CNOT gate may be configured to perform a NOT operation on the first input bit (to operate as a quantum NOT gate on the first input bit) under the condition that the second input qubit is 11), and to otherwise leave the first input bit unchanged. The output qubit resulting from the performance or not of the NOT gate operation on the first input bit, under the control of the control bit, may be indifferently referred to as the "result" bit or the "target" bit.

A quantum CNOT gate may be represented by the following matrix $cX$:

$$cX = \begin{bmatrix} 1 & 0 & 0 & 0 \\ 0 & 1 & 0 & 0 \\ 0 & 0 & 0 & 1 \\ 0 & 0 & 1 & 0 \end{bmatrix}$$

In the present subject disclosure, a quantum CNOT gate which performs a CNOT gate operation on quantum input data comprising a first qubit $|a\rangle$ and a second qubit $|b\rangle$ may sometimes be denoted $CNOT(|a,b\rangle)$. The operation of a CNOT gate may be represented as mapping the input qubits $|a, b\rangle$ to $|a, b \oplus a\rangle$:

$$|a, b\rangle \longmapsto |a, b \oplus a\rangle$$

where $\oplus$ represents a logical XOR operation.

The qubit on which the XOR is applied (or not) may be referred as the "target" qubit, whereas the qubit controlling the CNOT gate may be referred to as the "control" qubit.

With respect to an input qubit $|b\rangle$, the output target qubit of a quantum CNOT gate applied to $|b\rangle$ under the control qubit $|a\rangle$ may be denoted $|b \oplus a\rangle$.

The phase shift gates is a family of single-qubit quantum gates that map the basis states $|0\rangle$ and $|0\rangle$. The probability of measuring a $|1\rangle$ or $e^{i\varphi}|1\rangle$ is unchanged after applying this quantum gate, however it modifies the phase of the quantum state. The phase shift quantum gate is represented by the matrix:

$$P(\varphi) = \begin{bmatrix} 1 & 0 \\ 0 & e^{i\varphi} \end{bmatrix}$$

where $\varphi$ is the phase shift with the period $2\pi$.

As an example of phase shift gate, the quantum gate called "$T$ gate" is a phase shift quantum gate for $\varphi = \frac{\pi}{4}$, which may also be defined as a $\pi/4$ Pauli $Z$ rotation:

$$T = R_Z(\pi/4)$$

Fig. 1c shows a diagram representing a quantum T gate.

A Hadamard gate operates to map the states $|0\rangle$ and $|1\rangle$ to $\frac{|0\rangle+|1\rangle}{\sqrt{2}}$ and $\frac{|0\rangle-|1\rangle}{\sqrt{2}}$, respectively, and can be represented by a Hadamard matrix:

$$H = \frac{1}{\sqrt{2}} \begin{bmatrix} 1 & 1 \\ 1 & -1 \end{bmatrix}$$

Fig. 1d shows a diagram representing a quantum Hadamard gate.

Different (approximate) universal sets of quantum gates may be used for generating a quantum circuit.

For example, a set of quantum gates comprising gates of a Clifford set (which may also be called the Clifford group) ({CNOT, *Hadamard, S*}) and a T gate, which can advantageously be used in fault-tolerant quantum circuit design, may be used. A Clifford gate is a gate of the Clifford group, which is a set of mathematical transformations which represent a set of quantum operations which normalize the n-qubit Pauli group by mapping the set of n-fold Pauli group into itself. Gates of the Clifford group may be generated by three gates: the Hadamard gate, the phase gate S, and the CNOT gate.

As described above, the $T$ gate is a phase shift gate (operating a phase shift $\varphi = \frac{\pi}{4}$ ) that operates on one qubit which may be represented by the following transformation matrix:

$$T = \begin{bmatrix} 1 & 0 \\ 0 & e^{i\varphi} \end{bmatrix} \text{ with } \varphi = \frac{\pi}{4}.$$

A quantum (Hermitian) conjugate transpose T gate (sometimes also called "adjoint" *T* gate), which may be denoted $T^\dagger$ in the present subject disclosure, also operates on one qubit, and can be represented by the following matrix:

$$T^\dagger = \begin{bmatrix} 1 & 0 \\ 0 & e^{-i\varphi} \end{bmatrix}$$

The S gate is a one-qubit Clifford gate defined as follows:

$$S = T^2 = \begin{bmatrix} 1 & 0 \\ 0 & e^{i\varphi} \end{bmatrix} \text{ with } \varphi = \frac{\pi}{2}.$$

The resulting complexity of the quantum circuits proposed in the present subject disclosure according to embodiments directly depends on the gate set used for implementing the circuit (even though the Solovay-Kitaev theorem establishes a close connection between the complexities obtained with different universal gate sets).

Three main metrics can be used for purposes of assessing the complexity of a quantum circuit.

A first metric relates to the (quantum) width of the circuit, which corresponds to the number of qubits required to implement the circuit. While some qubits are necessary to the circuit as they are used in the one or more operations performed by the circuit, other qubits - sometimes referred to as "ancillary" - may typically be used as temporary computation space.

A second metric that may be used relates to the (quantum) cost, which corresponds to the number of gates in the circuit (as expressed in the form of a combination of 1-qubit and 2-qubit gates only (noting that any n-qubit gate with $n > 2$ can be decomposed into a combination of 1-qubit and 2-qubit gates)).

A third metric relates to the (quantum) delay, which corresponds to the depth of the circuit when it is expressed only with 1-qubit and 2-qubit gates. The quantum delay may be seen as providing information on how long the circuit will take to accomplish its task.

As discussed above, one of the main tasks of a quantum compiler is to reduce or minimize the resources needed to execute a given quantum algorithm. This reduction or minimization is important in the compilation stack as it makes quantum computation more practical and efficient. To complete this task effectively and decide which optimization to perform, one may first identify the most expensive operations hindering our way towards fast and functional quantum computation.

In this regard the T gate is often targeted as it cannot be trivially implemented, for instance via transversal operations, in a fault-tolerant way in most quantum error correcting codes as opposed to Clifford gates. It implies that implementing a T gate is generally much more costly than performing a Clifford gate operation. In addition, numerous quantum error correcting codes can be used to perform universal fault-tolerant quantum computation with the Clifford+T gate set. In such setup, the depth of a quantum circuit, and so the time required to execute it, may be deemed generally directly linked to the T-depth of the circuit. For this reason, much work has been put into the minimization of the T-depth in Clifford+T circuits. However, if the number of qubits at disposal is limited, then the depth of the circuit also depends on the number of T gates in the circuit. In addition, it may be considered that the depth of a circuit may dictate the minimum number of physical qubits needed to encode the logical qubits utilized to perform the fault-tolerant computation. The coherence time of the logical qubits must be greater than the time required to execute the whole circuit, and so the required amount of physical qubits per logical qubits increases as the depth of the circuit increases.

A feedback loop can then be contemplated as follows: if the depth of the circuit is diminished then less physical qubits are required to encode the logical qubits, which frees up qubits that can be used to further lower the depth of the circuit.

The reduction (or optimization) of the T-count (number of T gates in the circuit) can intervene at multiple stages of this process. Firstly, a lower T-count can induce a lower T-depth and so a lower circuit depth. In addition, the number of qubits required to implement the T gates may depend on the T-count. This is for example the case when the T gates are implemented via magic state distillation. As a consequence, reducing the number of T gates in a quantum circuit can lead to a lower number of T gates which can advantageously lower the number of physical qubits required to implement the quantum circuit.

The reduction (or optimization) of the T-count also has important applications outside of fault-tolerant quantum computation. Quantum compilers which have been designed for NISQ devices are incorporating a scheme for reducing the number of T gates. Reducing the T-count for these compilers can lead to shorter circuits and can help with the minimization of other gates such as the CNOT gate.

Besides compilation, T-count minimization also plays an important role in quantum circuit simulation. As stated by the Gottesman-Knill theorem, circuits composed of Clifford gates and Pauli measurements can be efficiently simulated by a classical computer. Extending the gate set by adding the T gate allows the simulation of universal quantum circuits at the cost of a significant increase in computational time as no algorithm is currently known to efficiently simulate these circuits. That is why many simulation techniques have a runtime that scales exponentially with respect to the number of T gates. Minimizing the number of T gates is then essential to exploit the full potential of these simulators and to push back the frontier of non-simulable quantum circuits.

In the following, quantum circuits that do not include any Hadamard quantum gate may be referred to as "Hadamard-free" circuits.

Conventional algorithms have been designed to reduce the number of T gates in quantum circuits composed of {*CNOT, S, T*} gates, that is, for Hadamard-free circuits. In order to use these algorithms for Clifford+T circuits, a pre-processing may be performed in one or more embodiments on the input circuit for circumventing the Hadamard gates in the input circuit.

Depending on the embodiments, such pre-processing, which may be referred to herein as "Hadamard-free pre-processing", may be performed for example according to one or more of the two following methods:

In a first Hadamard-free pre-processing method, the input circuit may be divided (e.g. partitioned) into Hadamard-free subcircuits and Clifford subcircuits containing Hadamard gates. The number of T gates in the Hadamard-free subcircuits can then be optimized using conventional T-count optimization algorithms designed for use with Hadamard-free circuits. Multiple strategies can be employed to create such a partition of the circuit, and it is generally preferred to regroup the T gates in the smallest possible number of Hadamard-free subcircuits to take advantage of the fact that the number of T gates in an Hadamard-free circuit can be upper bounded by $O(n^2)$, where $n$ is the number of qubits.

A second method to circumvent the Hadamard gates in the circuit relies on a measurement-based gadget which can substitute a Hadamard gate. This gadget may involve an ancilla qubit, a CZ gate and a measurement. If all the Hadamard gates in the circuits are gadgetized, then the circuit is Hadamard-free and the number of T gates can be optimized using algorithms specifically designed for Hadamard-free circuits. Only internal Hadamard gates, which are the Hadamard gates comprised between the first and the last T gates of the circuit, are required to be gadgetized. Indeed, if only the internal Hadamard gates are gadgetized then the circuit can be partitioned into an initial and final Clifford circuit and a Hadamard-free circuit in between containing all the T gates. The main drawback of this method is that one additional qubit must be used for each internal Hadamard gate that is gadgetized. This motivates the minimization of internal Hadamard gates. To do so, an algorithm which performs the synthesis of the sequence of Pauli rotations with a minimal number of internal Hadamard gates may advantageously be used.

Any Hadamard-free quantum circuit may be represented by an operator which may be referred to as a phase polynomial, as defined below:

A phase polynomial $p$ may be defined as a linear combination of linear Boolean functions:

$$p(x) = \sum_{i=1}^{m} a_i \left( y_1^{(i)} x_1 \oplus \ldots \oplus y_n^{(i)} x_n \right) \quad (mod\ 8)$$

(Equation 1)

where the vector $\left( y_k^{(i)} \right)_{k=1,\ldots,n}$ noted $\mathbf{y}^{(i)} \in \mathbb{Z}_2^n \backslash \{0\}$, the vector $(a_i)_{i=1,\ldots,m}$ noted $\mathbf{a} \in \mathbb{Z}_8^n$, and $m$ is a natural integer ($m \geq 0$).

In the present subject disclosure, the Boolean vector $\mathbf{y}^{(i)}$ (for a given index $i$) may sometimes be referred to as a "parity" of the phase polynomial $p$, the plurality of Boolean vectors $(\mathbf{y}^{(i)})_{i=1,\ldots,m}$ may sometimes be referred to as the "parities" of the phase polynomial $p$, and the Boolean vector $\alpha$ may sometimes be referred to as the "weights" of the phase polynomial $p$.

In one or more embodiments, a parity table denoted $P$ that corresponds to the phase polynomial $p$ (and therefore that corresponds to the input quantum circuit $C$) may be generated as a Boolean matrix of size $n \times m$, where $n$ may correspond to a number of qubits on which the input quantum circuit $C$ operates, and $m$ corresponds to a number of parities (weighted by a non-zero weight) in a phase polynomial $p$ that corresponds to the input quantum circuit $C$ (an example of which is given by Equation 1).

Such a parity table $P$ may be used in some embodiments of the present subject disclosure as a data table that describe the parities of a phase polynomial $p$ that corresponds to the input quantum circuit $C$ (according to a circuit-polynomial phase correspondence).

In one or more embodiments, a phase polynomial $p$ may be determined based on the input quantum circuit $C$ or on another phase polynomial $p'$ such that $p(x) = p'(x)$ for all $x$.

In one or more embodiments, such phase polynomial can then be used to implement the quantum gate $U_f$ via a phase polynomial synthesis algorithm, which will result in generating a quantum circuit containing a number $|\mathbf{a}\ (mod\ 2)|$ of T gates.

For purposes of embodiments which address the problem of minimizing the number of T gates in a quantum circuit, a parity $\mathbf{y}^{(i)}$ may be represented in the parity table $P$ if and only if its weight is satisfying $a_i \equiv 1 \ (mod\ 2)$. In particular, an even weight would correspond to a circuit that can be implemented with Clifford gates. For example, an even weight of $a_i = 2$ would correspond to a $\pi/2$-angle rotation, which also corresponds to the Clifford gate $S$.

Using this representation, the number of columns of the parity table $P$ is then equal to the number of T gates required to implement the phase polynomial $p$.

The following provides an example of weighted polynomial for a CCZ quantum gate.

The CCZ gate (which may be referred herein to as a "CCZ" gate) is a symmetric controlled quantum gate which operates on 3 qubits which include 1 output qubit and 2 control qubits.

The CCZ quantum gate operates to flip the phase of the $|111\rangle$ state:

$$CCZ = I \otimes I \otimes |0\rangle\langle 0| + CZ \otimes |1\rangle\langle 1|$$

A quantum CCZ gate may be represented by the following matrix $CCZ$:

$$CCZ = \begin{bmatrix} 1 & 0 & 0 & 0 & 0 & 0 & 0 & 0 \\ 0 & 1 & 0 & 0 & 0 & 0 & 0 & 0 \\ 0 & 0 & 1 & 0 & 0 & 0 & 0 & 0 \\ 0 & 0 & 0 & 1 & 0 & 0 & 0 & 0 \\ 0 & 0 & 0 & 0 & 1 & 0 & 0 & 0 \\ 0 & 0 & 0 & 0 & 0 & 1 & 0 & 0 \\ 0 & 0 & 0 & 0 & 0 & 0 & 1 & 0 \\ 0 & 0 & 0 & 0 & 0 & 0 & 0 & -1 \end{bmatrix}$$

In the present subject disclosure, a quantum CCZ gate which performs a CCZ gate operation on quantum input data comprising a first qubit $|x_1\rangle$, a second qubit $|x_2\rangle$ and a third qubit $|x_3\rangle$ may sometimes be denoted $CCZ(|x_1,x_2,x_3\rangle)$. The operation of a CCZ gate may be represented as mapping the input qubits ($|x_1,x_2,x_3\rangle$ to $(-1)^{x_1 x_2 x_3}|x_1,x_2,x_3\rangle$):

$$|x_1, x_2, x_3\rangle \mapsto (-1)^{x_1 x_2 x_3}|x_1, x_2, x_3\rangle$$

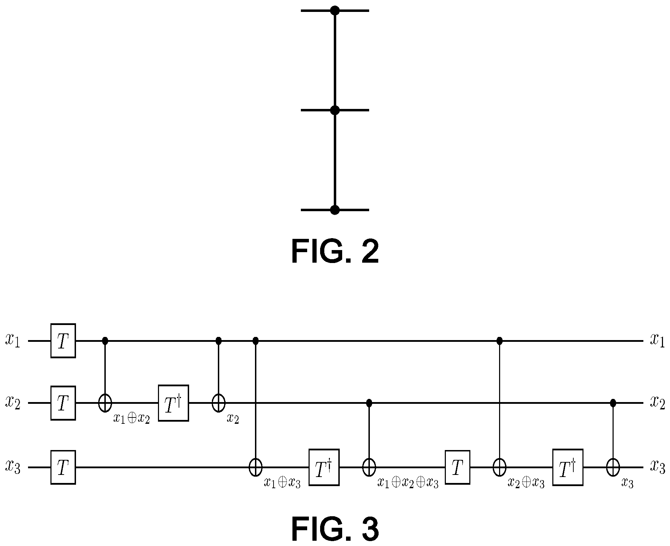

Figure 2 illustrates the so-called CCZ quantum gate.

For example, a phase polynomial $p(x_1,x_2,x_3)$ that can be used to implement the CCZ gate, may be defined as:

$$p(x_1, x_2, x_3) =$$
$$x_1 + x_2 + x_3 + 7(x_1 \oplus x_2) + 7(x_1 \oplus x_3) + (x_1 \oplus x_2 \oplus x_3) + 7(x_2 \oplus x_3)$$

One can verify that $p(x) = 1 \ (mod\ 8)$ if and only if $x$ is satifying $x_1 = x_2 = x_3 = 1$.

For example, a parity table $P$ and weights $a$ associated with the phase polynomial $p(x_1,x_2,x_3)$ may be generated as:

$$P = \begin{pmatrix} 1 & 0 & 0 & 1 & 1 & 1 & 0 \\ 0 & 1 & 0 & 1 & 0 & 1 & 1 \\ 0 & 0 & 1 & 0 & 1 & 1 & 1 \end{pmatrix}$$

And

$$a = \begin{pmatrix} 1 & 1 & 1 & 7 & 7 & 1 & 7 \end{pmatrix}^T$$

The synthesis of a phase polynomial $p$ with weights satisfying $a_i \in \mathbb{Z}_8$ for all $i$ can be realized using CNOT quantum gates and one $R_Z$ quantum gate with an angle of $a_i\pi/4$ for each parity $\mathbf{y}^{(i)}$ in the phase polynomial $p$.

An exemplary circuit implementing the phase polynomial $p(x_1,x_2,x_3)$ of this example with the CCZ gate is represented in Figure 3, which shows an exemplary implementation of the quantum gate having the he weighted

polynomial $f(x_1,x_2,x_3) = 4x_1x_2x_3$ which corresponds to the CCZ quantum gate (illustrated by Fig. 2).

In one or more embodiments, the equivalence between phase polynomials and their associated parity tables may also be described as follows:

A phase polynomial

$$p(\boldsymbol{x}) = \sum_{i=1}^{m} a_i\left(y_1^{(i)}x_1 \oplus \dots \oplus y_n^{(i)}x_n\right) \quad (mod\ 8)$$

can be put into its multilinear form as follows:

$$p(\boldsymbol{x}) = \sum_{i=1}^{m} a_i\left(\sum_{\alpha} y_\alpha^{(i)}x_\alpha - \sum_{\alpha<\beta} 2y_\alpha^{(i)}y_\beta^{(i)}x_\alpha x_\beta + \sum_{\alpha<\beta<\gamma} 4y_\alpha^{(i)}y_\beta^{(i)}y_\gamma^{(i)}x_\alpha x_\beta x_\gamma\right) \quad (mod\ 8)$$

This implies that two phase polynomials $p$ and $p'$, with associated parity tables $P$ and $P'$ respectively, are equivalent up to some Clifford operator if and only if the equation

$$\left|P'_\alpha \wedge P'_\beta \wedge P'_\gamma\right| \equiv \left|P_\alpha \wedge P_\beta \wedge P_\gamma\right| \quad (mod\ 2)$$

is satisfied for all $\alpha,\beta,\gamma$ satisfying $0 \leq a \leq \beta \leq \gamma < n$, where the notation $|v|$ refers to the Hamming weight of the vector $\boldsymbol{v}$.

The problem of finding a phase polynomial which can be implemented with a reduced (minimal) number of T gates and up to an operator implementable over the {CNOT, S} gate set may then be addressed in one or more embodiments through the following T-count optimization problem:

**Problem (T-count optimization).** Let $P$ be a Boolean matrix of size $n \times m$, where $n$ corresponds to a number of qubits on which a quantum circuit operates, and $m$ corresponds to a number of T quantum gates in the quantum circuit. Find a Boolean matrix $P'$ which has fewer columns than $P$ and such that:

$$\left|P'_\alpha \wedge P'_\beta \wedge P'_\gamma\right| \equiv \left|P_\alpha \wedge P_\beta \wedge P_\gamma\right| \quad (mod\ 2)$$

for all $\alpha,\beta,\gamma$ satisfying $0 \leq \alpha \leq \beta \leq \gamma < n$, where the notation $|\boldsymbol{v}|$ refers to the Hamming weight of the vector $\boldsymbol{v}$.

In the present subject disclosure, exemplary algorithms addressing the above-stated T-count optimization problem are provided as embodiments of the proposed data processing method. In addition, a performance analysis of some of the proposed algorithms shows that the number of T gates in the quantum circuit produced by these algorithms is upper bounded by $(n^2 + n)/2 + 1$.

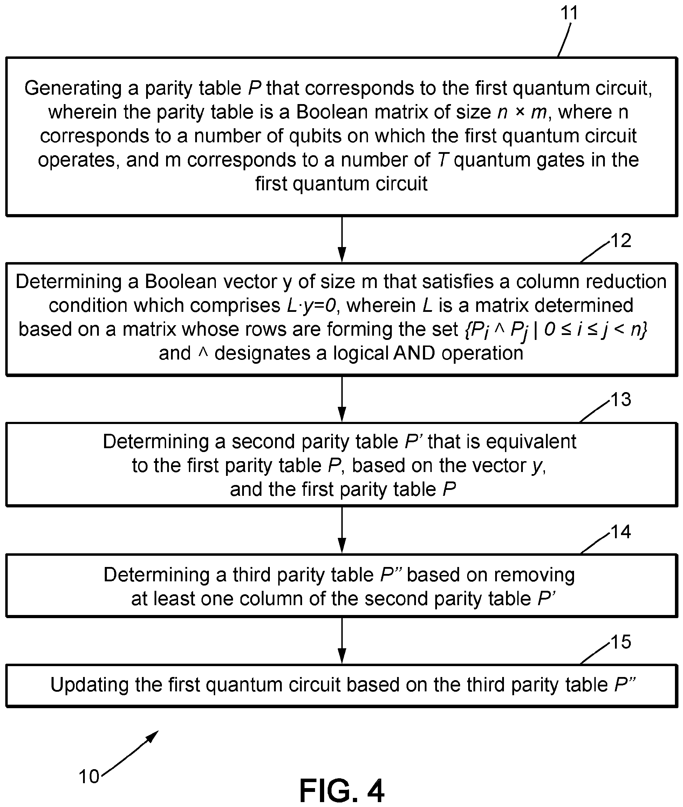

Fig. 4 shows a block diagram illustrating the data processing (10) of data representing a first quantum circuit that can be represented by a combination of quantum gates that comprises one or more T quantum gates.

Such data processing may advantageously be implemented using any suitable computational device, such as for example a quantum computational device (e.g. by a quantum processing node of a computer system), a non-quantum (classical) computational device, or a hybrid computational device comprising a quantum computational device and a non-quantum (classical) computational device, and provides performances that makes it particularly well suited for quantum computing, e.g. using a quantum circuit that has been optimized using embodiments of the present subject disclosure by reducing its number of T quantum gates.

In addition, such data processing may advantageously be implemented, e.g. on a classical processing device, for processing an input quantum circuit to be implemented on a quantum computational device or a hybrid computational device comprising a quantum computational device and a non-quantum (classical) computational device.

In the present subject disclosure, embodiments of the proposed data processing scheme are described in the context of quantum computing, that is, for implementation by a quantum computational device. In this context, the terms "bit" and "qubit" may be used interchangeably to designate a qubit. However, it will be appreciated by those having ordinary skill in the relevant art that any suitable computing environment, including a non-quantum computing environment or a hybrid quantum/non-quantum environment, may be used to implement the proposed scheme in place of the quantum computing context described herein, which is given by way of example only.

On may consider in some embodiments a first quantum circuit configured to operate on $n$ qubits, and which is represented by a combination of quantum gates that comprises one or more T quantum gates.

In one or more embodiments, a parity table $P$ that corresponds to the first quantum circuit may be generated (11). In some embodiments, the parity table may take the form of a Boolean matrix of size $n \times m$. In some embodiments, the number $n$ of lines of the parity table $P$ may correspond to a number of qubits on which the first quantum circuit operates. In some embodiments, the number $m$ may correspond to a first number of $T$ quantum gates of the first quantum circuit. In some embodiments, the number $m$ may correspond to a number of parities (in some embodiments weighted by a non-zero weight) in a phase polynomial $p$ that corresponds to the first quantum circuit.

In one or more embodiments, a Boolean vector $y$ of size $m$ (which may in some embodiments correspond to the number of parities in the phase polynomial $p$ that corresponds to the first quantum circuit) that satisfies a column reduction condition comprising $L \cdot y = 0$, where $L$ is a matrix determined based on a matrix whose rows are forming the set $\{P_i \wedge P_j | 0 \leq i \leq j < n\}$, wherein $P_k$ designates a vector corresponding to a row of index $k$ of the parity table $P$, and $\wedge$ designates a logical AND operation, may be determined (12).

In some embodiments, the matrix $L$ may be generated based on the first parity table $P$, and one or more vectors $y$ may be determined by searching for solutions of the matrix equation $L \cdot y = 0$. The matrix equation $L \cdot y = 0$, which corresponds to a system of linear equations, may be solved by any suitable conventional technique for solving systems of linear equations, such as for example Gaussian elimination.

In some embodiments, once one or more candidate vectors $y$ may be determined as solutions of the matrix equation $L \cdot y = 0$, and may then be tested for fulfilment of one or more other conditions that may be included in the column reduction condition.

In one or more embodiments, a second parity table $P'$ that is equivalent to the first parity table $P$ may then be determined (13) based on the vector $y$, and the first parity table $P$.

In one or more embodiments, a Boolean vector $z$ of size $n$ may be determined for which the second parity table $P'$ has at least one pair of columns that are identical to each other or at least one column which is equal to the null vector $0$, the second parity table $P'$ being based on $P \oplus zy^T$.

For example, in some embodiments, a vector $z$ of size $n$ may be determined based on a vector of a predetermined set of vectors $Z$, and the second parity table $P'$ may be based on $P \oplus zy^T$. Advantageously, the set of vectors $Z$ may be determined so that a second parity table $P'$ based on $P \oplus zy^T$ may include one or more of at least one pair of columns that are identical to each other, and at least one null column (that is, an all-zero column corresponding to the null vector $0$).

In one or more embodiments, the vector $z$ may be determined based on a vector of a set $Z$, wherein the set $Z$ comprises one or more of the subsets $\{P_{.,i} \oplus P_{.,j} | 0 \leq i < j < m\}$ and $\{P_{.,i} | 0 \leq i < m\}$, wherein $P_{.,k}$ is the column of index $k$ of the first parity table $P$.

In one or more embodiments, a third parity table $P''$ may be determined (14) based on removing at least one column of the second parity table $P'$.

In one or more embodiments, the third parity table may be used to update (15) the first quantum circuit based on the third parity table $P''$.

In embodiments where a vector $z$ is determined based on a vector of a set $Z$, iterations of a column reduction loop may be performed for determining an optimum (Boolean) vector $z_0$ of size $n$ based on the set of vectors $Z$ for which the second parity table $P'$ has a maximum number of pairs of columns that are identical to each other. In some embodiments, the optimum vector $z_0$ may be determined based on an objective function that counts the number of columns that can be removed from the second parity table as being one or more of all-zero columns and ones of a pair of columns that are duplicate from each other.

In one or more embodiments, a plurality of Boolean vectors $y$ that satisfy the column reduction condition which comprises $L \cdot y = 0$ may be determined, for example as a plurality of solutions of the matrix equation $L \cdot y = 0$. In some embodiments where the second parity table $P'$ is based on $P \oplus zy^T$ for respective vectors $y$ and $z$, one or more Boolean vectors $z$ of size $n$ may be determined for which, for a respective one of the determined plurality of Boolean vectors $y$, the second parity table $P'$ based on $P \oplus zy^T$ has at least one pair of columns that are identical to each other or at least one column which is an all-zero column. Determining a plurality of vectors $y$ that fulfil the column reduction condition advantageously allows testing such plurality of vectors for optimizing the T-count reduction. Likewise, determining a plurality of vectors $z$ for one of more of the determined plurality of vectors $y$ allows testing a plurality of pairs of vectors $y$ and $z$ for optimizing the T-count reduction. For example, in some embodiments, iterations of a column reduction loop may be performed for determining an optimum vector $y_0$ in the plurality of Boolean vectors $y$ and an optimum vector $z_0$ in the one or more Boolean vectors $z$ for which the second parity table $P'$ has a maximum number of columns that can be removed from the second parity table as being an all-zero column or one of a pair of columns that are identical to each other. In some embodiments, any suitable objective function may be used. For example, in some embodiments, the proposed scheme may comprise: maximizing the value $f(y_0, z_0)$ where $f$ is defined as the following objective function:

$$f(\boldsymbol{y}, \boldsymbol{z}) = -|\boldsymbol{y}| \ (mod \ 2) + \sum_{\{i,j\} \in S^{(z)}} 2(y_i \oplus y_j) + \delta_{ij}[y_i + 2(y_i \oplus 1)(|\boldsymbol{y}|(mod 2))]$$

Wherein $S^{(z)}$ comprises the set of indices $\{\{i,j\}P_{:,j} \oplus P_{:,j} = \boldsymbol{z}\} \cup \{\{i,i\}|P_{:,i} = \boldsymbol{z}\}$.

The following provides exemplary embodiments of the proposed scheme for processing a quantum circuit represented by an initial combination of quantum gates comprising one or more T gates so as to determine another representation of the quantum circuit corresponding to a reduced number of T gates as compared to the initial combination of quantum gates.

As discussed above, the problem of reducing the number of T gates in an initial quantum circuit may be stated through the corresponding "T-count optimization problem" described above.

In one or more embodiments, the following third order homogeneous polynomials elimination algorithm may be used for addressing the above-stated "T-count optimization problem".

Embodiments of the present subject disclosure for reducing the T-count of an initial quantum circuit use the following theorem (Theorem 1):

**Theorem 1.** Let $P$ be a parity table of size $n \times m$ and let

$$P' = \begin{cases} P \oplus \boldsymbol{zy}^T & \text{if } |\boldsymbol{y}| \equiv 0 \ (mod \ 2) \\ [P \oplus \boldsymbol{zy}^T \quad \boldsymbol{z}] & \text{if } |\boldsymbol{y}| \equiv 1 \ (mod \ 2) \end{cases}$$

where $\boldsymbol{z}$ and $\boldsymbol{y}$ are vectors of size $n$ and $m$ respectively such that:

$$|P_\alpha \wedge \boldsymbol{y}| \equiv 0 \ (mod \ 2)$$

$$|P_\alpha \wedge P_\beta \wedge \boldsymbol{y}| \equiv 0 \ (mod \ 2)$$

for all $0 \le \alpha < \beta < n,$ where $\wedge$ designates a logic AND, and $|\ |$ designates a Hamming weight of a vector.

Then we have:

$$|P'_\alpha \wedge P'_\beta \wedge P'_\gamma| \equiv |P_\alpha \wedge P_\beta \wedge P_\gamma| \ (mod \ 2)$$

for all $0 \le \alpha \le \beta \le \gamma < n$ , where $\wedge$ designates a logic AND, and $|\ |$ designates a Hamming weight of a vector.

This theorem can be proven as follows:

For all $\alpha, \beta, \gamma$ satisfying $0 \le \alpha \le \beta \le \gamma < n,$ we have: $|P'_\alpha \wedge P'_\beta \wedge P'_\gamma| = |(P_\alpha \oplus z_\alpha \boldsymbol{y}) \wedge (P_\beta \oplus z_\beta \boldsymbol{y}) \wedge (P_\gamma \oplus z_\gamma \boldsymbol{y})|$

$$|P'_\alpha \wedge P'_\beta \wedge P'_\gamma| = |[(P_\alpha \wedge P_\beta) \oplus z_\beta(P_\alpha \wedge \boldsymbol{y}) \oplus z_\alpha(P_\beta \wedge \boldsymbol{y}) \oplus z_\alpha z_\beta \boldsymbol{y})] \wedge (P_\gamma \oplus z_\gamma \boldsymbol{y})|$$

$$|P'_\alpha \wedge P'_\beta \wedge P'_\gamma| \equiv |P_\alpha \wedge P_\beta \wedge P_\gamma| + |z_\gamma(P_\alpha \wedge P_\beta \wedge \boldsymbol{y})| + |z_\beta(P_\alpha \wedge P_\gamma \wedge \boldsymbol{y})| + |z_\alpha(P_\beta \wedge P_\gamma \wedge \boldsymbol{y})|$$

$$+ |z_\beta z_\gamma(P_\alpha \wedge \boldsymbol{y})| + |z_\alpha z_\gamma(P_\beta \wedge \boldsymbol{y})| + |z_\alpha z_\beta(P_\gamma \wedge \boldsymbol{y})| + |z_\alpha z_\beta z_\gamma \boldsymbol{y}| \ (mod \ 2)$$

(Equation 2)

$$|P'_\alpha \wedge P'_\beta \wedge P'_\gamma| \equiv |P_\alpha \wedge P_\beta \wedge P_\gamma| \ (mod \ 2)$$

In some embodiments, Theorem 1 may therefore advantageously be used to define a set of column reduction conditions expressed on a vector $\boldsymbol{y}$ that selects a set of columns of the input parity table $P$.

If one chooses the vector $\boldsymbol{z}$ as $\boldsymbol{z} = P_{:,i} \oplus P_{:,j}$ where $i$ and $j$ are satisfying $y_i = 1$ and $y_j = 0$, then another parity table $P'$ may be obtained through the following operations:

$$P' = \begin{cases} P \oplus \boldsymbol{z}\boldsymbol{y}^T & if \ |y| \equiv 0 \ (mod \ 2) \\ [P \oplus \boldsymbol{z}\boldsymbol{y}^T \quad \boldsymbol{z}] & otherwise \end{cases}$$

By Theorem 1, $P'$ implements the same unitary gate as $P$ up to an operator implementable over the {CNOT, S} gate set.

The parity table $P'$ has at most one more column than $P$ and we have:

$$P'_{:,i} = P'_{:,j}$$

As a consequence, either one of the columns of respective indices $i$ and $j$ can be removed from $P'$, thereby reducing by one the number of columns of the parity table $P'$ (and correspondingly the T-count of the quantum circuit associated therewith).

Once one of the columns of respective indices $i$ and $j$ have been removed from $P'$, the parity table $P'$ has at least one less column than the parity table $P$.

Therefore, in cases where the number of columns of the parity table $P$ is strictly greater than $\frac{(n^2+n)}{2} + 1$ , the number of columns of $P$ can be reduced by at least one in polynomial time.

In addition, in cases where the number of columns of the parity table $P$ is equal to $\frac{(n^2+n)}{2} + 1$ and is even, a non-zero vector $\boldsymbol{y}$ satisfying $L\boldsymbol{y} = \boldsymbol{0}$ can advantageously be determined, as the matrix $L$ has $\frac{(n^2+n)}{2}$ rows.

Once the non-vector vector $\boldsymbol{y}$ satisfying $L\boldsymbol{y} = \boldsymbol{0}$ has been determined, it may be determined whether there exists an index $i$ such that $y_i = 0$. In case it is determined that there exists an index $i$ such that $y_i = 0$, the number of columns of the parity table P can be reduced as described above. Otherwise (in case there exists no index $i$ such that $y_i = 0$), then it means that the vector $\boldsymbol{y}$ fulfills the condition $|y| \equiv 0$ *(mod* 2). As a consequence, the vector $\boldsymbol{y}$ satisfies the Equations of Theorem 1 because $|\boldsymbol{y}| = 0$ *(mod* 2) and $L \cdot \boldsymbol{y} = \boldsymbol{0}$.

Therefore, if one determines the parity table $P'$ as defined by the equation:

$$P \oplus \boldsymbol{z}\boldsymbol{y}^T$$

where the vector $\boldsymbol{z}$ is equal to the ith column of the parity table $P$ for any $i$,
then such parity table $P'$ implements the same unitary gate as the parity table $P$ up to an operator implementable over the {CNOT, S} gate set.

The parity table $P'$ has the same number of columns as $P$ but its ith column is equal to the null vector $\boldsymbol{0}$ and can therefore be removed, which leads to a parity table $P''$ containing $\frac{(n^2+n)}{2}$ columns.

In one or more embodiments, the polynomial-time procedure described above to reduce the number of columns of the parity table $\boldsymbol{P}$ can be repeated, for example by performing iterations of a column reduction loop, until the parity table $\boldsymbol{P}$ has a number of columns lower or equal to:

$$2 \left\lfloor \frac{(n^2 + n)}{4} \right\rfloor + 1 \leq \frac{(n^2 + n)}{2} + 1$$

In one or more embodiments, the column reduction condition may comprise a one or more conditions of a set of predetermined conditions, for example expressed as conditions on the vector $\boldsymbol{y}$. For example, in some embodiments, the column reduction condition may comprise a combination of a plurality of conditions, and may be deemed satisfied in case at least one of the plurality of conditions is satisfied.

For example, in one or more embodiments, the column reduction condition may comprise one or more conditions for a second parity table parity table $P'$ based on $P \oplus \boldsymbol{z}\boldsymbol{y}^T$ to be equivalent to the first parity table $P$. As used herein, the terms parity table equivalency condition may sometimes be used herein for such a condition.

In some embodiments, one or more parity table equivalency conditions may be defined based on the conditions defined in Theorem 1 described herein.

For example, in some embodiments, the column reduction condition may comprise one or more conditions in a set of conditions which comprises a first column reduction condition (which may be viewed as a first parity table equivalency condition) expressed as (1) $L \cdot \mathbf{y} = \mathbf{0}$, with $\mathbf{y} \neq \mathbf{0}$ and $\mathbf{y} \neq \mathbf{1}$, and a second column reduction condition (which may be viewed as a second parity table equivalency condition) expressed as (2) $L \cdot \mathbf{y} = 0$, with $\mathbf{y} = \mathbf{1}$ and $|\mathbf{y}| \equiv 0 \ (mod \ 2)$, where $|\mathbf{y}|$ designates a Hamming weight of the vector y.

In one or more embodiments in which the column reduction condition comprises a first column reduction condition (which may be viewed as a first parity table equivalency condition) expressed as (1) $L \cdot \mathbf{y} = \mathbf{0}$, with $\mathbf{y} \neq \mathbf{0}$ and $\mathbf{y} \neq \mathbf{1}$, the proposed method may further comprise the determining of a vector $\mathbf{z}$ of size $n$ (in a set of vectors $Z$) for which a second parity table $P'$ based on $P \oplus \mathbf{zy}^T$ is equivalent to the first parity table $P$, and has at least one pair of columns that are identical to each other.

In one or more embodiments, based on the determined vector $\mathbf{y}$ satisfying $\mathbf{y} \neq \mathbf{0}$ and $\mathbf{y} \neq \mathbf{1}$, the second parity table $P'$ may be based on $P \oplus \mathbf{zy}^T$, wherein the vector $\mathbf{z}$ is a Boolean vector of size $n$ for which the second parity table $P'$ has at least one pair of columns that are identical to each other, and the at least one column removed for updating the second parity table $P'$ is one of the least one pair of columns that are identical to each other.

As stated by Theorem 1, for the parity table $P' = P \oplus \mathbf{zy}^T$ to be equivalent to the parity table $P$ (which is verified in cases where $\left| P'_\alpha \wedge P'_\beta \wedge P'_\gamma \right| \equiv \left| P_\alpha \wedge P_\beta \wedge P_\gamma \right| \ (mod \ 2)$ for all $0 \leq \alpha \leq \beta \leq \gamma < n$, where $\wedge$ designates a logic AND, and $| \ |$ designates a Hamming weight of a vector), the following conditions on the vector $\mathbf{y}$ may be required: (a1) a first condition expressed on the Hamming weight of vector $\mathbf{y}$ ($|\mathbf{y}| = 0 \ (mod \ 2)$ or $|\mathbf{y}| = 1 \ (mod \ 2)$), (b1) $|P_\alpha \wedge \mathbf{y}| = 0 \ (mod \ 2)$, and (c1) $|P_\alpha \wedge P_\beta \wedge \mathbf{y}| = 0 \ (mod \ 2)$, for all $0 \leq \alpha < \beta < n$, where $\wedge$ designates a logic AND, and $| \ |$ designates a Hamming weight of a vector.

Advantageously, in embodiments where a first column reduction condition (which may be viewed as a first parity table equivalency condition) expressed as (1) $L \cdot \mathbf{y} = \mathbf{0}$, with $\mathbf{y} \neq \mathbf{0}$ and $\mathbf{y} \neq \mathbf{1}$ is fulfilled by the vector $\mathbf{y}$, the second and third conditions of Theorem 1 ((b1) $|P_\alpha \wedge y| = 0 \ (mod \ 2)$, and (c1) $|P_\alpha \wedge P_\beta \wedge y| = 0 \ (mod \ 2)$, for all $0 \leq \alpha < \beta < n$) are fulfilled.

In one or more embodiments, the first condition (a1) of Theorem 1 on the Hamming weight of vector $\mathbf{y}$ may be addressed as follows: In a first case where $|\mathbf{y}| \equiv 0 \ (mod \ 2)$, the second second parity table $P'$ may be determined based on $P \oplus \mathbf{zy}^T$. In a second case where $|\mathbf{y}| \equiv 1 \ (mod \ 2)$, the second second parity table $P'$ may be determined based on adding the determined vector $\mathbf{z}$ (used in $P \oplus \mathbf{zy}^T$) as an additional column in a parity table based on $P \oplus \mathbf{zy}^T$) (for example $P' \leftarrow [P \oplus \mathbf{zy}^T \mathbf{z}]$). As a consequence, the conditions on the vector $\mathbf{y}$ contemplated in Theorem 1 may be fulfilled by one of the vectors $\mathbf{y}$ determined as solutions of the matrix equation $L.\mathbf{y} = \mathbf{0}$, so as to ensure that the second parity table $P'$ built based on $P \oplus \mathbf{zy}^T$ is equivalent to the first parity table $P$.

In one or more embodiments, the vectors $\mathbf{y}$ and $\mathbf{z}$ may be advantageously chosen so that the second parity table $P'$ built based on $P \oplus \mathbf{zy}^T$ is equivalent to the first parity table $P$, and such second parity table $P'$ comprises at least one pair of duplicate columns.

In such embodiments, the second parity table $P'$ may be (further) updated by removing at least one column (in some embodiments once (first) updated with an additional column based on the vector $\mathbf{z}$) which is identical to another column of the second parity table. In other embodiments, a third parity table $P''$ based on removing at least one column of the second parity table $P'$.

In some embodiments, the vector $\mathbf{z}$ may be determined based on a vector determined (selected) in a set $Z$ which comprises one or more of the subsets $\{P_{.,i} \oplus P_{.,j} | 0 < i < j < m\}$ and $\{P_{.,i} | 0 \leq i < m\}$, wherein $P_{.,k}$ is the column of index $k$ of the first parity table $P$, such as for example the set $\{P_{.,i} \oplus P_{.,j} | 0 \leq i < j < m\} \cup \{P_{.,i} | 0 \leq i < m\}$.

In one or more embodiments, the reduction of the number of T gates in the input circuit may be performed through removing one or more pairs of duplicate columns in a second parity table $P'$ which has been generated based on the first parity table $P$, the $\mathbf{y}$ vector and the $\mathbf{z}$ vector (e.g. based on $P \oplus \mathbf{zy}^T$), the $\mathbf{y}$ vector being selected so as to ensure that all the conditions stated in Theorem 1 for ensuring that the second parity table is equivalent to the first parity table are satisfied, and the $\mathbf{z}$ vector being selected in the set $Z$ so as to ensure that the second parity table includes at least one pair of duplicate columns.

In some embodiments, a vector $\mathbf{z}$ may be selected in the set of vectors $Z$ may for which a second parity table $P'$ which has been generated based on the first parity table $P$, the $\mathbf{y}$ vector and the selected $\mathbf{z}$ vector (e.g. based on $P \oplus \mathbf{zy}^T$) includes at least one pair of duplicate columns.

For example, in some embodiments, the set of vectors $Z$ may be searched to determine a vector $\mathbf{z}$ in this set for which a second parity table $P'$ which has been generated based on the first parity table $P$, the $\mathbf{y}$ vector and the $\mathbf{z}$ vector (e.g. based on $P \oplus \mathbf{zy}^T$) includes at least one pair of duplicate columns.

In one or more embodiments, one or more iterations of a first column reduction loop may be performed in order to determine an optimum vector $\mathbf{z_0}$ of size $n$ in the set of vectors $Z$ for which the second parity table $P'$ has a maximum number of pairs of columns that are identical to each other among the vectors of the set of vectors $Z$. The first column reduction loop may advantageously be performed in order to determine a maximum number of pairs of identical columns in the second parity table for reducing the number of columns of such table by removing one column of one or more (each) pairs of identical columns.

The determination of the optimum vector $z_0$ (for a given vector $y$) may be performed using any suitable optimization scheme, for example an optimization scheme that determines an optimum of an objective function.

Any suitable objective function, such as for example the following objective function:

$$-|y| \, (mod \, 2) + \sum_{\{i,j\} \in S^{(z)}} 2(y_i \oplus y_j) + \delta_{ij}[y_i + 2(y_i \oplus 1)(|y|(mod2))]$$

wherein $S^{(z)}$ comprises the set of indices $\{\{i,j\}|P_{.,i} \oplus P_{.,j} = z\} \cup \{\{i,i\}|P_{.,i} = z\}$, may be used for that purpose.

In embodiments in which the above exemplary objective function is used, the set of indices $S^{(z)}$ may be determined by performing iterations of a second column reduction loop, an iteration of the second column reduction loop comprising: For a vector $z$ of the set $Z$ respectively corresponding to the iteration, computing a pair of indices $\{i,j\}$ that satisfies (a) $P_{.,i} \oplus P_{.,j} = z$ in a case where $i \ne j$ or (b) $P_{.,i} = z$ in a case where $i = j$.

In one or more embodiments in which the column reduction condition comprises a second column reduction condition (which may be viewed as a second parity table equivalency condition) expressed as (2) $L \cdot y = 0$, with $y = 1$ and $|y| \equiv 0 \, (mod \, 2)$, the second parity table $P'$ may be based on $P \oplus P_{.,i} 1^T$, that is, $P \oplus P_{:,i} y^T$, where $i$ is a column index of the parity table P. In such embodiments, the vector $z$ may therefore be chosen based on $P_{.,i}$.

In such embodiments where the vector $y$ satisfies a second column reduction condition (which may be viewed as a second parity table equivalency condition) expressed as (2) $L \cdot y = 0$, with $y = 1$ and $|y| \equiv 0 \, (mod \, 2)$, such condition coincides with the first case of the first condition (a1) of Theorem 1 ($|y| \equiv 0 \, (mod \, 2)$), which is then naturally fulfilled (satisfied) by the vector $y$.

In one or more embodiments, based on the vector $y$ satisfying $y = 1$ and $|y| = 0 \, (mod \, 2)$, wherein $|y|$ designates a Hamming weight of the vector $y$, the second parity table $P'$ may be based on $P \oplus P_{.,i} y^T$, wherein $P_{.,i}$ is the column of index $i$ of the first parity table $P$. In such embodiments, the at least one column removed for updating the second parity table $P'$ may be equal to the null (all-zero) vector.

In one or more embodiments in which the column reduction condition comprises a second column reduction condition expressed as (2) $L \cdot y = 0$, with $y = 1$ and $|y| \equiv 0 \, (mod \, 2)$, the at least one column removed for updating the second parity table $P'$ may be equal to the null vector.

In one or more embodiments, the third parity table $P''$, which is equivalent to the first parity table however with a reduced number of columns (in some embodiments an optimized number of columns) as compared to the first parity table, may be used to update the first (initial) quantum circuit, resulting in the generation of a second quantum circuit. In some embodiments, the third parity table $P''$ may be used to generate a second quantum circuit. Thanks to the proposed data processing, the second quantum circuit may have a reduced T-count as compared to the (initial) first quantum circuit. In some embodiments, the second quantum circuit, resulting from embodiments of the proposed subject disclosure, may be produced, in any suitable (tangible or intangible) form, so as to be executed on a quantum computational system.

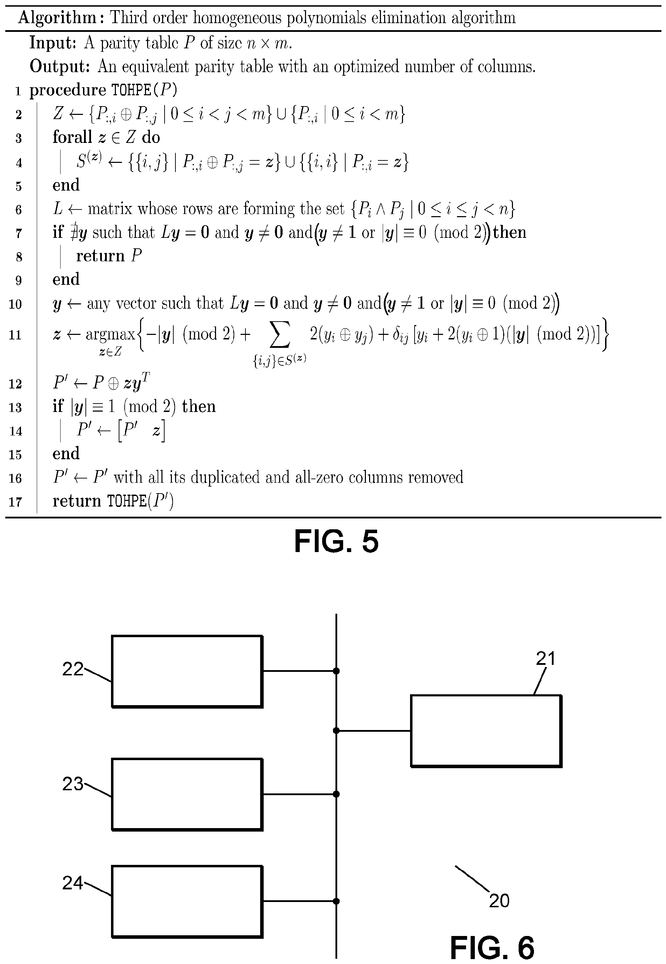

Figure 5 shows an exemplary third order homogenous polynomials elimination algorithm, which may be referred to herein as the "TOHPE" algorithm, according to one or more embodiments of the present subject disclosure.

The skilled person will understand that the sequence of actions shown on Fig. 5 is only exemplary and that such actions may be performed in a sequence different from that illustrated on Fig. 5.

In one or more embodiments, the input data to the TOHPE algorithm may comprise a parity table $P$ that corresponds to a first quantum circuit. The first quantum circuit may be represented by a combination of quantum gates that comprises one or more $T$ quantum gates, so that it may have a given T-count. The TOHPE algorithm may be executed on the parity table $P$ that corresponds to the circuit so as to reduce (in some embodiments minimize) the T-count of the (input) first quantum circuit.

In one or more embodiments, the TOHPE algorithm may therefore perform data processing operations on data of a parity table $P$ that corresponds to a first quantum circuit.

As described above in further details, the parity table $P$ may be a Boolean matrix of size $n \times m$, where $n$ may correspond to a number of qubits on which the first quantum circuit operates, and $m$ corresponds to a number of parities (e.g. weighted by a non-zero weight) in a phase polynomial $p$ that corresponds to the first quantum circuit. In some embodiments, the number of columns $m$ of the parity table $P$ may correspond to a first T-count, that is, a first number of $T$ quantum gates (required to implement the phase polynomial $p$) used in a first implementation of the first quantum circuit.

As a consequence, the TOHPE algorithm may be executed on the parity table $P$ that corresponds to the first quantum circuit so as to reduce (in some embodiments minimize) the number of columns of the parity table $P$.

In one or more embodiments, the data processing operations performed on the parity table $P$ may comprise the computing of a set $Z$ which contains a plurality of vectors $z$ which can potentially be used to transform $P$ (e.g. via Theorem 1) and reduce its number of columns. In some embodiments, a set $Z$ which contains all vectors $z$ which may be used to transform $P$ (e.g. via the above-stated Theorem 1) and reduce its number of columns may be determined.

For example, in some embodiments, the following set $Z$ may be determined (Line 2 of the exemplary TOHPE algorithm of Fig. 5):

$$\left\{P_{:,i} \oplus P_{:,j} \middle| 0 \le i < j < m\right\} \cup \left\{P_{:,i} \middle| 0 \le i < m\right\}$$

Depending on the embodiment, the determined set $Z$ may comprise vectors of one or more of a first set of vectors and a second set of vectors.

In one or more embodiments, vectors of the first set may be obtained based on adding (e.g. through a logical AND operation) pairs of (distinct) columns of the parity table $P$. In some embodiments, the vectors of the first set may be obtained based on adding (e.g. through a logical AND operation) all possible pairs of (distinct) columns of the parity table $P$ ($\{P_{:,i} \oplus P_{:,j}|0 < i < j < m\}$).

In one or more embodiments, vectors of the second set may be obtained based on columns of the parity table $P$. In some embodiments, $m$ vectors of the second set may be obtained based respectively on each of the $m$ columns of the parity table $P$ ($\{P_{:,i}|0 \le i \le m\}$).

In one or more embodiments, a set $S^{(z)}$ of pair of indices $\{i,j\}$ satisfying $P_{:,i} \oplus P_{:,j} = z$ in the case where $i \ne j$ or satisfying $P_{:,i} = z$ in the case where $i = j$ may be computed for one or more vectors $z \in Z$.

In some embodiments, the set $S^{(z)}$ of pair of indices $\{i,j\}$ satisfying $P_{:,i} \oplus P_{:,j} = z$ in the case where $i \ne j$ or satisfying $P_{:,i} = z$ in the case where $i = j$ may be computed for each vector $z \in Z$. The determination of the set $S^{(z)}$ in such embodiments may be performed in some embodiments through a loop as illustrated by lines 3 - 5 of the exemplary TOHPE algorithm of Fig. 5).

In one or more embodiments, the algorithm may comprise operations for identifying a vector $y$ that can be used with a plurality of (in some embodiments all) the vectors z that are determined by the algorithm, for example as follows: In one or more embodiments, a matrix $L$ with rows labelled by $(\alpha\beta)$ such that $L_{\alpha\beta} = P_\alpha \wedge P_\beta$ for all $\alpha < \beta$ is determined.

For example, in some embodiments, a matrix whose rows are forming the set $\{P_i \wedge P_j|0 \le i \le j < n\}$, wherein $P_k$ designates a vector corresponding to a row of index $k$ of the parity table $P$, may be determined as the matrix $L$ used by the TOHPE algorithm, as illustrated by line 6 of the exemplary TOHPE algorithm of Fig. 5. The matrix $L$ may be determined in some embodiments in order to apply one or more of the conditions stated by the Theorem 1.

In one or more embodiments, the proposed algorithm may determine whether a vector $y$ of size $m$ that satisfies a column reduction condition can be determined.

Depending on the embodiment, the column reduction condition may comprise one or more of a first column reduction condition and a second column reduction conduction.

In some embodiments, the first column reduction condition may be stated based on the following: $L \cdot y = 0$ and $y \ne 0$ and $y \ne 1$.

As described above in further details, the above stated exemplary first column reduction condition may be used in some embodiments (e.g. in order to exploit the Theorem 1).

Therefore, in some embodiments the algorithm may determine whether a vector y that satisfies a first column reduction condition stated based on (e.g. as) $L \cdot y = 0$ and $y \ne 0$ and $y \ne 1$ can be determined (in order to exploit the Theorem 1). As discussed above, in the cases where the condition $L \cdot y = 0$ and $y \ne 0$ and $y \ne 1$ is satisfied by the determined vector $y$, such vector $y$ may be used to reduce the number of columns of the parity table $P$.

In some embodiments, one or more candidate vectors $y$ may be determined as one or more respective solutions of the matrix equation $L.y = 0$, and one of these candidate vectors which verifies the additional conditions $y \ne 0$ and $y \ne 1$ may be selected. In some embodiments where a plurality of candidate vectors determined as respective solutions of the matrix equation $L.y = 0$, one of these candidate vectors may be selected randomly.

However, as also discussed above in further details, in the cases where $L \cdot y = 0$ and $y = 1$ and $|y| \equiv 0\ (mod\,2)$, the number of columns of the parity table $P$ may still be reduced.

In some embodiments, the second column reduction condition may therefore be stated based on the following: $L \cdot y = 0$ and $y = 1$ and $|y| \equiv 0\ (mod\,2)$.

As described above in further details, the above stated exemplary second column reduction condition may be used in some embodiments in order to reduce the number of columns of the parity table $P$.

Therefore, in some embodiments the algorithm may determine whether a vector y that satisfies a second column reduction condition stated based on (e.g. as) $L \cdot y = 0$ and $y = 1$ and $|y| \equiv 0\ (mod\,2)$ can be determined. As discussed above, in the cases where the condition $L \cdot y = 0$ and $y = 1$ and $|y| \equiv 0\ (mod\,2)$ is satisfied by the determined vector $y$, such vector $y$ may be used to reduce the number of columns of the parity table $P$.

Indeed, as in such case the vector y satisfies all the conditions of Theorem 1, the parity table $P'$ defined as $P' = P \oplus P_{:,1}1^T$ for any $i$ is equivalent to $P$, and its ith column is equal to the null vector, and can therefore advantageously be removed, which reduces the number of columns by one, thereby reducing the number of quantum T gates of the first quantum circuit corresponding to the parity table $P$.

In one or more embodiments, the algorithm may advantageously use a combination of column reduction conditions based on the above stated first and second column reduction conditions, since the number of columns of the parity table $P$ may be reduced as long as the determined vector $y$ satisfies at least one of the conditions: (a) $L \cdot y = 0$ and $y \neq 0$ and $y \neq 1$ and (b) $L \cdot y = 0$ and $y = 1$ and $|y| \equiv 0$ (mod 2).

In one or more embodiments, the proposed algorithm may end in cases where a vector y of size $m$ that satisfies a column reduction condition cannot be determined.

For example, in cases where a vector $y$ that satisfies at least one of predetermined column reduction conditions, such as for example (a) $L \cdot y = 0$ and $y \neq 0$ and $y \neq 1$ and (b) $L \cdot y = 0$ and $y = 1$ and $|y| \equiv 0$ (mod 2), cannot be determined, the algorithm may stop and return the input parity table $P$, as illustrated by lines 7-9 of the exemplary TOHPE algorithm of Fig. 5).

For example, if no solution of the matrix equation $L \cdot y = 0$ that satisfies either $y \neq 0$ and $y \neq 1$ or $y = 1$ and $|y| \equiv 0$ (mod 2) can be found, the algorithm may stop and return the input parity table $P$.

In one or more embodiments, otherwise (in cases where at least one vector $y$ that satisfies at least one of predetermined column reduction conditions, such as for example (a) $L \cdot y = 0$ and $y \neq 0$ and $y \neq 1$ and (b) $L \cdot y = 0$ and $y = 1$ and $|y| \equiv 0$ (mod 2), has been determined), the at least one vector y may be stored in memory, as illustrated by line 10 of the exemplary TOHPE algorithm of Fig. 5.

For example, in one or more embodiments, once the matrix $L$ is generated, the algorithm may proceed to determine solutions of the matrix equation $L \cdot y = 0$. Among the determined solutions of the matrix equation $L \cdot y = 0$, a $y$ vector that satisfies either or may then be selected. Depending on which additional condition the selected vector $y$ satisfies, the algorithm may proceed to reduce the number of column of a parity table which is equivalent to that corresponding to the input circuit.

In one or more embodiments where a vector $y$ has been determined that satisfies $L \cdot y = 0$, depending on the additional condition satisfied by the vector $y$, the algorithm may proceed to select a vector $z$ in the previously determined set $Z$ (as illustrated by line 2 of the exemplary TOHPE algorithm of Fig. 5) such that one or more of at least one duplicated column and at least one all-zero columns in the parity table $P' = P \oplus zy^T$ may be determined for the parity table $P'$ which is equivalent (or can be made equivalent) to the parity table $P$.

In some embodiments, the algorithm may proceed to select a vector $z$ in the previously determined set $Z$ (as illustrated by line 2 of the exemplary TOHPE algorithm of Fig. 5) such that the total number of columns that may be removed that corresponds to a combination (e.g. a sum) of the number of duplicated columns with the number of all-zero columns in the parity table $P' = P \oplus zy^T$ is maximized.

This total number of columns corresponds to the number of columns that can be removed from $P$ if the corresponding vector $z$ is selected (minus one in the case where $|y| \equiv 1$ (mod 2)). In some embodiments, the corresponding vector $z$ may be determined based on an objective function to be maximized, such as for example the following objective function which calculates a number of columns to be removed (deleted) at the end of the proposed scheme (e.g. the exemplary algorithm of Fig. 5) for a given vector $y$ (e.g. in the exemplary algorithm of Fig. 5 the number of columns deleted in the parity table for a vector $z$, that is, the number of columns in the parity table $P$ minus the number of columns in the parity table $P''$):

$$-|y| \ (mod \ 2) + \sum_{\{i,j\} \in S^{(z)}} 2\left(y_i \oplus y_j\right) + \delta_{ij}\left[y_i + 2(y_i \oplus 1)(|y| \ (mod \ 2))\right]$$

where $\delta$ is the Kronecker delta defined as follows:

$$\delta_{ij} = \begin{cases} 0 & if \quad i \neq j \\ 1 & if \quad i = j \end{cases}$$

as illustrated by line 11 of the exemplary TOHPE algorithm of Fig. 5.

In one or more embodiments, the determination of a vector $z$ in the set $Z$ that maximizes the number of columns that can be removed may be performed using a column reduction loop by iterating over the set $Z$ to determine, for a given vector $y$, for one or more (e.g. each) candidate vectors $z$ of the set $Z$ the total number of columns that may be removed in case of selecting such candidate vector $z$.

In some embodiments, such iterations can be performed over a subset of the set $Z$.

In one or more embodiments, once a vector $z$ has been selected in the set $Z$, a second parity table $P'$ which is equivalent to the first parity table $P$ and can be updated to contain fewer columns than the first parity table $P$ may be determined, for example based on the following operation: $P \oplus zy^T$, as illustrated by line 12 of the exemplary TOHPE algorithm of Fig. 5.

For example, in some embodiments, once a vector $z$ maximizing an objective function (such as the above exemplary objective function) has been found in the set $Z$, a second parity table $P'$ which is equivalent to the first parity table $P$ and can be updated to contain fewer columns than the first parity table $P$ may be determined, for example based on the following operation: $P \oplus zy^T$, as illustrated by line 12 of the exemplary TOHPE algorithm of Fig. 5.

In embodiments where at least one vector y that satisfies the column reduction condition (a) $L \cdot y = 0$ and $y \neq 0$ and $y \neq 1$ has been determined, a second parity table $P'$ determined based on $P \oplus zy^T$ may advantageously have at least two identical columns (one of which may therefore be removed in order to reduce the number of columns of the parity matrix).

In embodiments where at least one vector y that satisfies the column reduction condition (b) $L \cdot y = 0$ and $y = 1$ and $|y| \equiv 0 \ (mod \ 2)$ has been determined, a second parity table $P'$ determined based on $P \oplus zy^T$ may advantageously include at least one all-zero column (which may therefore be removed in order to reduce the number of columns of the parity matrix).

In embodiments where at least one vector $y$ that satisfies the column reduction condition (a) $L \cdot y = 0$ and $y \neq 0$ and $y \neq 1$ has been determined, a second parity table P' may be determined based on $P \oplus zy^T$.

In some embodiments, in cases where the additional condition $|y| = 1 \ (mod \ 2)$ is satisfied, a column equal to the selected vector $z$ may be added to the second parity matrix $P'$. For example, the second parity matrix $P'$ may be updated by adding a column equal to the selected vector $z$, such as illustrated by lines 13 - 15 of the exemplary TOHPE algorithm of Fig. 5: $P' = [P' \ z]$.

In one or more embodiments, the second parity table may be updated by removing one or more of the duplicated columns and the all-zero columns, as illustrated by line 16 of the exemplary TOHPE algorithm of Fig. 5, resulting in some embodiments in a third parity table $P''$.

In one or more embodiments, an execution of the proposed algorithm (such as the exemplary TOHPE algorithm of Fig. 5) on an (input) first parity table may result in a third parity table resulting from the removal of one or more of duplicated columns and all-zero column(s) from a second parity table determined based on the first parity table on the basis of a predetermined column reduction condition. In some embodiments, a recursive call of the algorithm may be performed on the third parity table in order to further reduce, if possible, the number of columns of the input parity table as illustrated by line 17 of the exemplary TOHPE algorithm of Fig. 5: *return* $TOHPE(P')$. As discussed above, a column reduction algorithm according to the present subject disclosure may be configured to end in cases where no vector y that satisfies at least one column reduction condition can be found, as illustrated by lines 7 - 9 of the exemplary TOHPE algorithm of Fig. 5.

In one or more embodiments, a variant of the exemplary THOPE algorithm of Fig. 5 may be used, which is configured for finding both vectors $z$ and $y$ that are maximizing the objective function, instead of first determining a vector $y$ based on a (predetermined) column reduction condition and then selecting in a set $Z$ a vector $z$ that can be used with the vector $y$ to determine the second parity table.

In one or more embodiments, once a third parity table $P''$ has been determined by removing at least one column for the second parity table $P'$, the (initial) quantum circuit may be updated based on the third parity table $P''$ in order to obtain a quantum circuit that corresponds to the third parity table $P''$, and that has a T-count which is lower than that of the initial quantum circuit.

In some embodiments, once a third parity table $P''$ has been determined by removing at least one column for the second parity table $P'$, the third parity table $P''$ may be used to generate a second quantum circuit. Thanks to the proposed data processing, the second quantum circuit may have a reduced T-count as compared to the (initial) first quantum circuit.

In one or more embodiments, the second quantum circuit, resulting from embodiments of the proposed subject disclosure, may be produced, in any suitable (tangible or intangible) form, so as to be executed on a quantum computational system.

As the parity table $P$ describes a phase polynomial, any suitable, current or future, phase polynomial synthesis algorithm may be used to construct a quantum circuit in which the number of T gates is equal to the number of columns in the parity table $P$.

Performances of the exemplary algorithm of Fig. 5 are described in the following, in a case of an exemplary implementation of this algorithm in the Rust programming language:

We first consider in the following embodiments where ancillary qubits are available.

Performances of such embodiments where ancillary qubits are available are presented in Table 1 below.

| Circuit | Pre-optimization | | | TOHPE | |
|---|---|---|---|---|---|
| | $n$ | $h$ | $T$-count | $T$-count | t (s) |
| $\mathrm{Tof}_3$ | 5 | 2 | 15 | 13 | 0.00 |
| $\mathrm{Tof}_4$ | 7 | 4 | 23 | 19 | 0.00 |
| $\mathrm{Tof}_5$ | 9 | 6 | 31 | 25 | 0.00 |
| $\mathrm{Tof}_{10}$ | 19 | 16 | 71 | 55 | 0.00 |
| Barenco $\mathrm{Tof}_3$ | 5 | 3 | 16 | 13 | 0.00 |
| Barenco $\mathrm{Tof}_4$ | 7 | 7 | 28 | 23 | 0.00 |
| Barenco $\mathrm{Tof}_5$ | 9 | 11 | 40 | 33 | 0.00 |
| Barenco $\mathrm{Tof}_{10}$ | 19 | 31 | 100 | 83 | 0.02 |
| $\mathrm{Mod5}_4$ | 5 | 0 | 8 | 7 | 0.00 |
| VBE Adder$_3$ | 10 | 4 | 24 | 19 | 0.00 |
| CSLA MUX$_3$ | 15 | 6 | 62 | 41 | 0.00 |
| CSUM MUX$_9$ | 30 | 12 | 84 | 71 | 0.01 |
| QCLA Com$_7$ | 24 | 18 | 95 | 59 | 0.00 |
| QCLA Mod$_7$ | 26 | 58 | 237 | 171 | 0.03 |
| QCLA Adder$_{10}$ | 36 | 25 | 162 | 111 | 0.03 |
| Adder$_8$ | 24 | 37 | 173 | 119 | 0.02 |
| Mod Adder$_{1024}$ | 28 | 304 | 1011 | 661 | 1.65 |
| RC Adder$_6$ | 14 | 10 | 47 | 37 | 0.00 |
| Mod Red$_{21}$ | 11 | 17 | 73 | 53 | 0.00 |
| Mod Mult$_{55}$ | 9 | 3 | 35 | 17 | 0.00 |
| $GF(2^4)$ Mult | 12 | 0 | 68 | 59 | 0.00 |
| $GF(2^5)$ Mult | 15 | 0 | 115 | 83 | 0.00 |
| $GF(2^6)$ Mult | 18 | 0 | 150 | 119 | 0.00 |
| $GF(2^7)$ Mult | 21 | 0 | 217 | 164 | 0.00 |
| $GF(2^8)$ Mult | 24 | 0 | 264 | 211 | 0.01 |
| $GF(2^9)$ Mult | 27 | 0 | 351 | 265 | 0.02 |
| $GF(2^{10})$ Mult | 30 | 0 | 410 | 317 | 0.04 |
| $GF(2^{16})$ Mult | 48 | 0 | 1040 | 831 | 0.20 |
| $GF(2^{32})$ Mult | 96 | 0 | 4128 | 3257 | 7.82 |
| $GF(2^{64})$ Mult | 192 | 0 | 16448 | 13059 | 226.90 |
| $GF(2^{128})$ Mult | 384 | 0 | 65664 | 52339 | 11669.26 |
| $GF(2^{256})$ Mult | 768 | 0 | 262400 | 220442 | - |
| $GF(2^{512})$ Mult | 1536 | 0 | 1048576 | 1036270 | - |
| Adder$_{1024}$ | 2048 | 2044 | 8184 | 6139 | 9901.08 |
| Adder$_{2048}$ | 4096 | 4092 | 16376 | 12298 | - |
| Adder$_{4096}$ | 8192 | 8188 | 32760 | 31674 | - |
| DEFAULT | 640 | 11936 | 39744 | 38638 | - |
| Shor$_4$ | 25 | 5010 | 17052 | 10929 | 83838.69 |

In some embodiments, each of the circuits listed in Table 1 implementing the TOHPE algorithm may be pre-optimized, using any suitable procedure such as the Hadamard-free pre-processing procedure described above, to minimize the number of internal Hadamard gates.

Further, in some embodiments, all the internal Hadamard gates may be gadgetized to obtain a circuit without internal Hadamard gates, using any suitable procedure, such as described above with respect to Hadamard-free circuits.

This method of optimization can increase the number of CNOT gates in the circuit.

In some embodiments, a phase polynomial synthesis algorithm may be used to perform the synthesis of the phase polynomial produced by the T-count optimizer with an optimized number of CNOT gates.

The TOHPE procedure advantageously provides a low T-count for most of the circuits on which it is used.

An exemplary architecture of a computational device according to the present subject disclosure is illustrated on Fig. 6, which shows a computational device (20) configured to perform a data processing method in accordance with embodiments of the present subject disclosure.

The computational device (20) includes a data processing engine (21), an input interface (22), an output interface (23), and a memory (24).

In the architecture illustrated on Fig. 6, all of the input interface (22), output interface (23), and memory (24) are operatively coupled with one another through the data processing engine (21).

In some embodiments, the input interface (22) is configured for receiving input data representing a first quantum circuit represented by a combination of quantum gates that comprises one or more T quantum gates, and transmitting such input data to the data processing engine (21) for further processing according to embodiments of the present subject disclosure.

In some embodiments, the output interface (23) is configured for outputting data representing a result of a processing according to embodiments of the present subject disclosure, such as, for example, output data representing a quantum circuit whose T-count is smaller than that of the first quantum circuit represented by input data received by the input interface (22).

In some embodiments, the data processing engine (21) is configured for performing data processing functions according to embodiments of the present subject disclosure. For example, depending on the embodiment, the data processing engine (21) may be configured for performing one or more operations of a method comprising: Generating a parity table P that corresponds to a first quantum circuit, wherein the parity table is a Boolean matrix of size $n \times m$, where $n$ may correspond to a number of qubits on which the first quantum circuit operates, and $m$ corresponds to a number of $T$ quantum gates in the first quantum circuit, determining a Boolean vector $\boldsymbol{y}$ of size m that satisfies a column reduction condition which comprises $L \cdot \boldsymbol{y} = \boldsymbol{0}$, wherein $L$ is a matrix determined based on a matrix whose rows are forming the set $\{P_i \wedge P_j | 0 \le i \le j < n\}$, wherein $P_k$ designates a vector corresponding to a row of index $k$ of the parity table $P$, and $\wedge$ designates a logical AND operation, determining a second parity table $P'$ that is equivalent to the first parity table $P$, based on the vector $\boldsymbol{y}$, and the first parity table $P$, determining a third parity table $P''$ based on removing at least one column of the second parity table $P'$; and updating the first quantum circuit based on the third parity table $P''$.

In some embodiments, the data processing engine (21) may include or may be included in a processor, which may be, depending on the embodiment, any suitable quantum processor (such as, for example any suitable quantum processing unit (QPU) and/or state machine, or a combination thereof), any suitable non-quantum processor (such as, for example any suitable computer processing unit (CPU) and/or state machine, or a combination thereof), or a combination thereof.

In some embodiments, the data processing engine (21) may implement a quantum logic-gate based circuit using, depending on the embodiment, any suitable quantum computing technology and architecture (e.g. trapped ion, neutral atoms in optical lattices, superconducting, superconductor spin qubits, photonics, superconducting transmon, nuclear magnetic resonance).

The data processing engine (21) may also comprise, or may be in communication with, (quantum and/or non-quantum) computer storage media, such as, without limitation, the memory (24) (which may include a quantum memory, a non-quantum memory or a combination thereof). In some embodiments, the memory (24) may be any type of quantum data storage or quantum computer storage medium coupled to the data processing engine (21) and operable with the interfaces (22) and (23) to facilitate management of data held/stored in association therewith, such as, for example, any memory configured for storing quantum data comprising qubits (e.g. an atomic gas quantum memory, a solid quantum memory, a gradient echo memory and any combination thereof). In some embodiments, the memory (24) may be any type of non-quantum data storage or non-quantum computer storage medium coupled to the data processing engine (21) and operable with the interfaces (22) and (23) to facilitate management of data held/stored in association therewith, such as, for example, any memory configured for storing data representing qubits.

It will be appreciated that the computational device (20) shown and described with reference to Fig. 6 is provided by way of example only. Numerous other architectures, operating environments, and configurations are possible. Other embodiments of the device may include fewer or greater number of components, and may incorporate some or all of the functionality described with respect to the device components shown in Fig. 6. Accordingly, although the input interface (22), output interface (23), memory (24), and data processing engine (21) are illustrated as part of the device (20), no restrictions are placed on the location and control of components (21) - (24). In particular, in other embodiments, components (21) - (24) may be part of different entities or computing systems.

In particular, the device (20) may be embedded in a classical computer system, a classical computing unit, a quantum computer system, a quantum computing unit, a hybrid computer system, any combination thereof, or any other device comprising a (quantum, non-quantum or hybrid) processor operatively coupled with a (quantum or non-quantum) memory.

The device (20), and more generally any device configured for implementing embodiments of the present subject disclosure, may be implemented in software, in hardware, or in a combination of software and hardware.

Although this subject disclosure has been disclosed in the context of certain preferred embodiments, it should be understood that certain advantages, features and aspects of the systems, devices, and methods may be realized in a variety of other embodiments. Additionally, it is contemplated that various aspects and features described herein can be practiced separately, combined together, or substituted for one another, and that a variety of combination and sub-combinations of the features and aspects can be made and still fall within the scope of the subject disclosure. Furthermore, the systems and devices described above need not include all of the modules and functions described in the preferred embodiments.

Information and signals described herein can be represented using any of a variety of different technologies and techniques. For example, data, instructions, commands, information, signals, bits, symbols, and chips can be represented by voltages, currents, electromagnetic waves, magnetic fields or particles, optical fields or particles, or any combination thereof.

Depending on the embodiment, certain acts, events, or functions of any of the methods described herein can be performed in a different sequence, may be added, merged, or left out all together (e.g., not all described acts or events are necessary for the practice of the method). Moreover, in certain embodiments, acts or events may be performed concurrently rather than sequentially.

## Claims

1. A data processing method for processing a first quantum circuit represented by a combination of quantum gates that comprises one or more $T$ quantum gates, the method comprising:

   • Generating a parity table $P$ that corresponds to the first quantum circuit, wherein the parity table is a Boolean matrix of size $n \times m$, where $n$ corresponds to a number of qubits on which the first quantum circuit operates, and $m$ corresponds to a number of $T$ quantum gates in the first quantum circuit;
   • Determining a Boolean vector $\boldsymbol{y}$ of size $m$ that satisfies a column reduction condition which comprises $L \cdot \boldsymbol{y} = \boldsymbol{0}$, wherein $L$ is a matrix determined based on a matrix whose rows are forming the set $\{P_i \wedge P_j | 0 \leq i \leq j < n\}$, wherein $P_k$ designates a vector corresponding to a row of index $k$ of the parity table $P$, and $\wedge$ designates a logical AND operation;
   • Determining a second parity table $P'$ that is equivalent to the first parity table $P$, based on the vector $\boldsymbol{y}$, and the first parity table $P$;
   • Determining a third parity table $P''$ based on removing at least one column of the second parity table $P'$; and
   • Updating the first quantum circuit based on the third parity table $P''$.

2. The method according to claim 1, further comprising:

   Determining a Boolean vector $\boldsymbol{z}$ of size $n$ for which the second parity table $P'$ has at least one pair of columns that are identical to each other or at least one column which is equal to the null vector, wherein the second parity table $P'$ is based on $P \oplus \boldsymbol{z}\boldsymbol{y}^T$, and $\oplus$ designates a logical XOR operation.

3. The method according to any of the preceding claims, further comprising:

   Based on the additional condition $|\boldsymbol{y}| \equiv 1 \, (mod \, 2)$ being satisfied by the vector $\boldsymbol{y}$, wherein $|\boldsymbol{y}|$ designates a Hamming weight of the vector $\boldsymbol{y}$, updating the second parity table $P'$ by adding the determined vector $\boldsymbol{z}$ as an additional column in the second parity table $P'$, wherein the at least one column removed for updating the second parity table $P'$ is identical to another column of the second parity table updated by adding the additional column.

4. The method according to any of the preceding claims, wherein based on the vector y satisfying $\boldsymbol{y} = \boldsymbol{1}$ and $|\boldsymbol{y}| \equiv 0 \, (mod \, 2)$, wherein $|\boldsymbol{y}|$ designates a Hamming weight of the vector $\boldsymbol{y}$, the second parity table $P'$ is based on $P \oplus P_{.,i}\boldsymbol{y}^T$, wherein $P_{.,i}$ is the column of index $i$ of the first parity table $P$, $\oplus$ designates a logical XOR operation, and the at least one column removed for updating the second parity table $P'$ is equal to the null vector.

5. The method according to any of claims 1 to 3, wherein based on the vector $\boldsymbol{y}$ satisfying $\boldsymbol{y} \neq \boldsymbol{0}$ and $\boldsymbol{y} \neq \boldsymbol{1}$, the second parity table $P'$ is based on $P \oplus \mathbf{z}\mathbf{y}^T$, wherein $\oplus$ designates a logical XOR operation, wherein the vector $\mathbf{z}$ is a Boolean vector of size $n$ for which the second parity table $P'$ has at least one pair of columns that are identical to each other, and the at least one column removed for updating the second parity table $P'$ is one of the least one pair of columns that are identical to each other.

6. The method according to claim 2, further comprising: determining the vector z based on a vector of a set $Z$, wherein the set $Z$ comprises one or more of the subsets $\{P_{:,i} \oplus P_{:,j} | 0 \leq i < j < m\}$ and $\{P_{:,i} | 0 \leq i < m\}$, wherein $P_{:,k}$ is the column of index $k$ of the first parity table $P$, and $\oplus$ designates a logical XOR operation.

7. The method according to claim 6, further comprising: performing iterations of a column reduction loop for determining an optimum vector $\mathbf{z}_0$ of size $n$ in the set of vectors $Z$ for which the second parity table $P'$ has a maximum number of pairs of columns that are identical to each other among the vectors of the set of vectors $Z$.

8. The method according to claim 7, wherein the optimum vector $\mathbf{z}_0$ is determined based on an objective function that counts the number of columns that can be removed from the second parity table as being all-zero columns or ones of a pair of columns that are duplicate from each other.

9. The method according to any of the preceding claims, further comprising:

   Determining a plurality of Boolean vectors $\mathbf{y}$ that satisfy the column reduction condition which comprises $L \cdot \mathbf{y} = \mathbf{0}$,
   Determining one or more Boolean vectors $\mathbf{z}$ of size $n$ for which, for a respective one of the plurality of Boolean vectors $\mathbf{y}$, the second parity table $P'$ has at least one pair of columns that are identical to each other or at least one column which is an all-zero column,
   wherein the second parity table $P'$ is based on $P \oplus \mathbf{z}\mathbf{y}^T$, and $\oplus$ designates a logical XOR operation.

10. The method according to claim 9, further comprising: performing iterations of a column reduction loop for determining an optimum vector $\mathbf{y}_0$ in the plurality of Boolean vectors $\mathbf{y}$ and an optimum vector $\mathbf{z}_0$ in the one or more Boolean vectors $\mathbf{z}$ for which the second parity table $P'$ has a maximum number of columns that can be removed from the second parity table as being an all-zero column or one of a pair of columns that are identical to each other.

11. The method according to claims 7-8 and 10, further comprising: maximizing the value $f(\mathbf{y}_0, \mathbf{z}_0)$ where $f$ is defined as the following objective function:

$$f(\mathbf{y}, \mathbf{z}) = -|\mathbf{y}| \,(mod\ 2) + \sum_{\{i,j\} \in S^{(\mathbf{z})}} 2(y_i \oplus y_j) + \delta_{ij}[y_i + 2(y_i \oplus 1)(|y|(mod 2))]$$

Wherein $S^{(\mathbf{z})}$ comprises the set of indices $\{\{i,j\} | P_{:,i} \oplus P_{:,j} = \mathbf{z}\} \cup \{\{i,i\} | P_{:,i} = \mathbf{z}\}$, and $\oplus$ designates a logical XOR operation.

12. The method according to any of the preceding claims, further comprising: producing a second quantum circuit that corresponds to the first quantum circuit updated based on the third parity table.

13. A computational device, the device comprising a processor and a memory operatively coupled to the processor, wherein the device is configured to perform a method according to any of claims 1 to 12.

14. A computer program product comprising computer program code embodied in a computer readable medium, said computer program code comprising instructions to, when provided to a computer system and executed, cause said computer to perform a method according to any of claims 1 to 12.

15. A data set representing, for example through compression or encoding, a computer program product according to claim 14.

$|a\rangle$ ———— $\oplus$ ———— $|\bar{a}\rangle$

**FIG. 1a**

$|a\rangle$ ———— $\bullet$ ———— $|a\rangle$

$|b\rangle$ ———— $\oplus$ ———— $|b \oplus a\rangle$

**FIG. 1b**

$\boxed{T}$

**FIG. 1c**

$\boxed{H}$

**FIG. 1d**

FIG. 2

FIG. 3

11

Generating a parity table $P$ that corresponds to the first quantum circuit, wherein the parity table is a Boolean matrix of size $n \times m$, where n corresponds to a number of qubits on which the first quantum circuit operates, and m corresponds to a number of $T$ quantum gates in the first quantum circuit

12

Determining a Boolean vector y of size m that satisfies a column reduction condition which comprises $L{\cdot}y{=}0$, wherein $L$ is a matrix determined based on a matrix whose rows are forming the set $\{P_i \wedge P_j \mid 0 \leq i \leq j < n\}$ and $\wedge$ designates a logical AND operation

13

Determining a second parity table $P'$ that is equivalent to the first parity table $P$, based on the vector $y$, and the first parity table $P$

14

Determining a third parity table $P''$ based on removing at least one column of the second parity table $P'$

15

Updating the first quantum circuit based on the third parity table $P''$

10

# FIG. 4

---

**Algorithm:** Third order homogeneous polynomials elimination algorithm

---

**Input:** A parity table $P$ of size $n \times m$.

**Output:** An equivalent parity table with an optimized number of columns.

**procedure** TOHPE($P$)

$\quad Z \leftarrow \{P_{:,i} \oplus P_{:,j} \mid 0 \leq i < j < m\} \cup \{P_{:,i} \mid 0 \leq i < m\}$

$\quad$ **forall** $z \in Z$ **do**

$\quad\quad$ $S^{(z)} \leftarrow \{\{i,j\} \mid P_{:,i} \oplus P_{:,j} = z\} \cup \{\{i,i\} \mid P_{:,i} = z\}$

$\quad$ **end**

$\quad L \leftarrow$ matrix whose rows are forming the set $\{P_i \wedge P_j \mid 0 \leq i \leq j < n\}$

$\quad$ **if** $\nexists y$ such that $Ly = 0$ and $y \neq 0$ and $\big(y \neq 1$ or $|y| \equiv 0 \pmod 2\big)$ **then**

$\quad\quad$ **return** $P$

$\quad$ **end**

$\quad y \leftarrow$ any vector such that $Ly = 0$ and $y \neq 0$ and $\big(y \neq 1$ or $|y| \equiv 0 \pmod 2\big)$

$\quad z \leftarrow \underset{z \in Z}{\mathrm{argmax}} \Big\{ -|y| \pmod 2 + \sum_{\{i,j\} \in S^{(z)}} 2(y_i \oplus y_j) + \delta_{ij} \left[ y_i + 2(y_i \oplus 1)(|y| \pmod 2) \right] \Big\}$

$\quad P' \leftarrow P \oplus zy^T$

$\quad$ **if** $|y| \equiv 1 \pmod 2$ **then**

$\quad\quad$ $P' \leftarrow \begin{bmatrix} P' & z \end{bmatrix}$

$\quad$ **end**

$\quad P' \leftarrow P'$ with all its duplicated and all-zero columns removed

$\quad$ **return** TOHPE($P'$)

---

# FIG. 5

# FIG. 6

Europäisches
Patentamt

European
Patent Office

Office européen
des brevets

# EUROPEAN SEARCH REPORT

**Application Number**

EP 24 30 5679

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | VIVIEN VANDAELE ET AL: "Optimal Hadamard gate count for Clifford+T synthesis of Pauli rotations sequences", ARXIV.ORG, CORNELL UNIVERSITY LIBRARY, 201 OLIN LIBRARY CORNELL UNIVERSITY ITHACA, NY 14853, 24 February 2024 (2024-02-24), XP091688525, DOI: 10.1145/3639062 * abstract * * page 1 - page 29 * | 1-15 | INV. G06N10/20 |
| A | Ruiz Francisco J ET AL: "Quantum Circuit Optimization with AlphaTensor", , 5 March 2024 (2024-03-05), XP093214593, Retrieved from the Internet: URL:https://arxiv.org/pdf/2402.14396 [retrieved on 2024-10-14] * the whole document * | 1-15 | |
| A | MOSCA MICHELE ET AL: "A polynomial time and space heuristic algorithm for T-count", QUANTUM SCIENCE AND TECHNOLOGY, [Online] vol. 7, no. 1, 28 October 2021 (2021-10-28), page 015003, XP093213694, ISSN: 2058-9565, DOI: 10.1088/2058-9565/ac2d3a Retrieved from the Internet: URL:https://iopscience.iop.org/article/10.1088/2058-9565/ac2d3a/pdf> [retrieved on 2024-10-14] * the whole document * | 1-15 | TECHNICAL FIELDS SEARCHED (IPC) G06N |

-/--

The present search report has been drawn up for all claims

| Place of search | Date of completion of the search | Examiner |
|---|---|---|
| The Hague | 14 October 2024 | Tsakonas, Athanasios |

page 1 of 2

| | Europäisches Patentamt European Patent Office Office européen des brevets | **EUROPEAN SEARCH REPORT** | | **Application Number** EP 24 30 5679 |
|---|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CLARINO DAVID ET AL: "Optimizing LUT-Based Quantum Circuit Synthesis Using Relative Phase Boolean Operations", 2023 IEEE/ACM INTERNATIONAL CONFERENCE ON COMPUTER AIDED DESIGN (ICCAD), IEEE, 28 October 2023 (2023-10-28), pages 1-8, XP034479210, DOI: 10.1109/ICCAD57390.2023.10323730 [retrieved on 2023-11-30] * the whole document * ----- | 1-15 | |
| | | | **TECHNICAL FIELDS SEARCHED (IPC)** |

The present search report has been drawn up for all claims

| Place of search | Date of completion of the search | Examiner |
|---|---|---|
| The Hague | 14 October 2024 | Tsakonas, Athanasios |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)